(19) Europäisches Patentamt / European Patent Office / Office européen des brevets

(11) **EP 1 705 491 B1**

(12) **EUROPEAN PATENT SPECIFICATION**

(45) Date of publication and mention
of the grant of the patent:
**19.06.2013 Bulletin 2013/25**

(51) Int Cl.:
***G01R 31/12*** *(2006.01)*

(21) Application number: **06004130.8**

(22) Date of filing: **01.03.2006**

(54) **Partial discharge detection method and apparatus**

Verfahren und Vorrichtung für die Teilentladungsdetektion

Méthode et appareil de détection de décharge partielle

(84) Designated Contracting States:
**CH DE FR GB IT LI NL**

(30) Priority: **23.03.2005 JP 2005084305**

(43) Date of publication of application:
**27.09.2006 Bulletin 2006/39**

(73) Proprietors:
• **The Tokyo Electric Power Co., Inc.**
**Tokyo 100-8560 (JP)**
• **MITSUBISHI DENKI KABUSHIKI KAISHA**
**Chiyoda-ku**
**Tokyo 100-8310 (JP)**

(72) Inventors:
• **Nishida, Chieko**
**Chiyoda-ku,**
**Tokyo 100-8310 (JP)**
• **Kamei, Mitsuhito**
**Chiyoda-ku,**
**Tokyo 100-8310 (JP)**
• **Okabe, Shigemitsu, c/o The Tokyo Elect. Power Cie**
**Tokyo 100-8560 (JP)**

• **Kaneko, Shuhei, c/o The Tokyo Elect. Power Cie,**
**Tokyo 100-8560 (JP)**
• **Muto, Hirotaka**
**Chiyoda-ku,**
**Tokyo 100-8310 (JP)**
• **Yoshimura, Manabu**
**Chiyoda-ku,**
**Tokyo 100-8310 (JP)**

(74) Representative: **Sajda, Wolf E. et al**
**Meissner, Bolte & Partner GbR**
**Widenmayerstrasse 48**
**80538 München (DE)**

(56) References cited:
• **MUTO H ET AL: "Resonance characteristics and identification of modes wave excited by partial discharges in GIS" HIGH VOLTAGE ENGINEERING, 1999. ELEVENTH INTERNATIONAL SYMPOSIUM ON (CONF. PUBL. NO. 467) LONDON, UK 23-27 AUG. 1999, LONDON, UK,IEE, UK, vol. 5, 23 August 1999 (1999-08-23), pages 70-73, XP006501742 ISBN: 0-85296-719-5**

**Description**

BACKGROUND OF THE INVENTION

1. FIELD OF THE INVENTION

The present invention relates to a method of determining partial discharge and a system for determining partial discharge for determining whether or not a partial discharge occurs in gas-insulated equipment.

2. DESCRIPTION OF THE RELATED ART

As a known technique for detecting partial discharge, which is indicative of an insulation defect occurring in gas-insulated electrical equipment; for example, in an insulated electrical apparatus in which a high voltage conductor is supported by an insulator in a sealed metal container filled with insulating gas, as a method of diagnosing a defect in the gas-insulated electrical apparatus for diagnosing a defect occurring inside, there is a known technique in which a high frequency signal is extracted from the sealed metal container, the high frequency signal is separated into a plurality of individual frequency regions, and the amplitude of each of the high frequency signals of each frequency region is compared to determine the presence or absence of a defect in the gas-insulated electrical apparatus and the distance from an observation point to the point where the defect occurs. Signals separated by signal separating means are TE11, TE21, TM01, TM12, and TE31 modes etc., which are higher modes with respect to a TEM mode of a fundamental mode propagating in a two conductor system. The signals indicate the absolute intensity or relative intensity of these high frequency signals and computing is performed using these high frequency signals, if needed, to determine the presence or absence of a defect in the gas-insulated electrical apparatus and the distance from the observation point to the point where the defect occurs, when it is determined that a defect exists (refer to JP-A-2000-102159) to MUTO H: Resonance characteristics and identification ..., High Voltage Engineering, ISNB 0-852 96-719-5.

In such a known gas-insulated diagnostic method, as a sensor for detecting a high frequency signal generated by partial discharge, a shield electrode preliminarily embedded in an insulating spacer for supporting a conductor is used. The shield electrode is configured so as to be mounted in an outer circumferential direction adjacent to an insulating spacer in a ring shape so as to surround the insulating spacer so that the high frequency signal propagating in the metal container is detected by the shield electrode in the insulating spacer part. Each mode included in the high frequency signal is separated by a filter utilizing a cutoff frequency which is determined by the diameter of the center conductor and the diameter of the metal container, and it is determined that the mode is present if there is energy in those frequency regions. As described, since an electromagnetic wave signal due to the partial discharge is separated by only the frequency region, a detection region broadly covers the frequency region in which those higher modes possibly exist; it is therefore difficult to distinguish whether the signal is derived from the partial discharge or merely from external noise when any energy is detected in measuring. Thus, there remains a problem in that countermeasures against noise are required in general partial discharge diagnosing technology in substations, where strong environmental noise exists.

SUMMARY OF THE INVENTION

The present invention has been made to solve the problem described above, and an object of the present invention is to provide a highly reliable method of determining partial discharge and system for determining partial discharge that can determine the presence or absence of a partial discharge, with being less affected by external noise. This is achieved by focusing on the TE11 mode or the TE21 mode, from the high order TE modes determined by the structure of the gas-insulated equipment, among high frequency signals caused by partial discharge, which allows effective use of the feature that they exhibit a significant intensity distribution particularly in the circumferential direction of a tank of the gas-insulated equipment.

A method of determining partial discharge according to the present invention, wherein gas-insulated equipment, which is configured so that a cylindrical metal tank sealed with insulating gas is partitioned by insulating spacers and a center conductor is supported by the insulating spacers, is to be observed for determining the presence or absence of a partial discharge generated in the metal tank, the method includes the steps of: detecting an electromagnetic wave signal at a plurality of outer circumferential positions of the insulating spacer with an electromagnetic wave detector, the electromagnetic wave signal propagating in the metal tank; extracting a signal of a frequency band in which a TE11 mode propagates but a TE21 mode does not propagate by utilizing a cutoff frequency from the detected electromagnetic wave signal, with a TE11 envelope detector; detecting an intensity distribution of outer circumferential electromagnetic waves in the metal tank with an intensity detector from the intensity of the extracted signal and the circumferential position information of the electromagnetic wave detector; and determining the presence or absence of a partial discharge depending on whether or not the intensity distribution is indicative of a distribution peculiar to the TE11 mode.

Further, a system for determining partial discharge according to the present invention includes: an electromagnetic wave detector for detecting an electromagnetic wave signal at a plurality of outer circumferential positions of an insulating spacer, the electromagnetic wave signal propagating in a metal tank; a TE11 envelope detector for extracting a signal of a frequency band in which a TE11 mode propagates but a TE21 mode does not propagate by utilizing a cutoff frequency by receiving the detected electromagnetic wave signal; and an intensity detector for detecting an intensity distribution of outer circumferential electromagnetic waves in the metal tank from the intensity of the extracted signal and the circumferential position information of the electromagnetic wave detector.

According to the method of determining partial discharge or the system for determining partial discharge of the present invention, the method or the system performs: detecting an electromagnetic wave signal at a plurality of outer circumferential positions of an insulating spacer; extracting a signal of a frequency band in which a TE11 mode propagates but a TE21 mode does not propagate with a TE11 envelope detector; detecting an intensity distribution of an outer circumferential electromagnetic waves in a metal tank from the intensity of the extracted signal and the circumferential position information of an electromagnetic wave detector; and determining the presence or absence of a partial discharge depending on whether or not the intensity distribution is indicative of a distribution peculiar to the TE11 mode, and therefore, a signal of the TE 11 mode included in an electromagnetic wave caused by a partial discharge can be effectively captured and a feature peculiar to the mode can be extracted, thereby enabling the provision of a method of determining partial discharge or a system for determining partial discharge which can determine the presence or absence of a partial discharge with high reliability, without being affected by external noise.

Further, a method of determining partial discharge adds a determining device which determines the presence or absence of a partial discharge by comparing the intensity distribution of electromagnetic waves obtained by an intensity detector with the distribution peculiar to the TE11 mode.

Further, a system for determining partial discharge includes a determining device which determines the presence or absence of a partial discharge by comparing the intensity distribution detected by an intensity detector with the distribution peculiar to the TE11 mode.

According to the method of determining partial discharge and the system for determining partial discharge, the presence or absence of a partial discharge is determined by using a determining device by comparing the intensity distribution of electromagnetic waves obtained by an intensity detector with the distribution peculiar to the TE11 mode, and therefore, the determining accuracy can be increased, in addition to the aforementioned effects.

Further, a method of determining partial discharge according to the present invention performs: detecting an electromagnetic wave signal at a plurality of outer circumferential positions of an insulating spacer with an electromagnetic wave detector, the electromagnetic wave signal propagating in a metal tank; extracting a signal of a frequency band in which a TE21 mode propagates but a TE31 mode does not propagate by utilizing a cutoff frequency from the detected electromagnetic wave signal, with a TE21 envelope detector; detecting an intensity distribution of outer circumferential electromagnetic waves in the metal tank with an intensity detector from the intensity of the extracted signal and the circumferential position information of the electromagnetic wave detector; and determining the presence or absence of a partial discharge depending on whether or not the intensity distribution is indicative of a distribution peculiar to the TE21 mode.

Further, a system for determining partial discharge according to the present invention includes: an electromagnetic wave detector for detecting an electromagnetic wave signal at a plurality of outer circumferential positions of an insulating spacer, the electromagnetic wave signal propagating in a metal tank; a TE21 envelope detector for extracting a signal of a frequency band in which a TE21 mode propagates but a TE31 mode does not propagate by utilizing a cutoff frequency by receiving the detected electromagnetic wave signal; and an intensity detector for detecting an intensity distribution of outer circumferential electromagnetic waves in the metal tank from the intensity of the extracted signal and the circumferential position information of the electromagnetic wave detector.

According to the method of determining partial discharge or a system for determining partial discharge of the present invention, the method or the system performs: detecting an electromagnetic wave signal at a plurality of outer circumferential positions of an insulating spacer; extracting a signal of a frequency band in which a TE21 mode propagates but a TE31 mode does not propagate with a TE21 envelope detector; detecting an intensity distribution of an outer circumferential electromagnetic waves in a metal tank from the intensity of the extracted signal and the circumferential position information of an electromagnetic wave detector; and determining the presence or absence of a partial discharge depending on whether or not the intensity distribution is indicative of a distribution peculiar to the TE21 mode, and therefore, a signal of the TE21 mode included in an electromagnetic wave caused by a partial discharge can be effectively captured and a feature peculiar to the mode can be extracted, thereby enabling the provision of a method of determining partial discharge or a system for determining partial discharge which can determine the presence or absence of a partial discharge with high reliability, without being affected by external noise.

Further, a method of determining partial discharge adds a determining device which determines the presence or absence of a partial discharge by comparing the intensity distribution of electromagnetic waves obtained by an intensity detector with the distribution peculiar to the TE21 mode.

Furthermore, a system for determining partial discharge includes a determining device which determines the presence or absence of a partial discharge by comparing the intensity distribution detected by an intensity detector with the distribution peculiar to the TE21 mode.

According to the method of determining partial discharge and the system for determining partial discharge, the presence or absence of a partial discharge is determined by using a determining device by comparing the intensity distribution of electromagnetic waves obtained by an intensity detector with the distribution peculiar to the TE21 mode, and therefore, the determining accuracy can be increased, in addition to the aforementioned effects.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a view in which a system for determining partial discharge according to Embodiment 1 of the present invention is mounted on gas-insulated equipment.

Fig. 2 is a cross-sectional view taken along the line II-II of Fig. 1.

Fig. 3 is a typical view showing an electromagnetic field distribution of a TEM mode, TE11 mode, and TE21 mode in a coaxial line.

Fig. 4 is a view showing an example of an intensity distribution of electromagnetic wave when a partial discharge occurs in a metal tank.

Fig. 5 is a view for explaining a method of determining partial discharge of a straight pipe metal tank according to Embodiment 1 of the present invention.

Fig. 6 is a view showing another example of a determining section of the system for determining partial discharge of Fig. 1.

Fig. 7 is a view showing one example of an intensity distribution pattern obtained by the determining section of Fig. 6.

Fig. 8 is a view for explaining a method of determining partial discharge of an L shaped metal tank according to Embodiment 2 of the present invention.

Fig. 9 is a view showing another example for explaining a method of determining partial discharge of the L shaped metal tank according to Embodiment 2 of the present invention.

Fig. 10 is a view showing other example for explaining a method of determining partial discharge of the L shaped metal tank according to Embodiment 2 of the present invention.

Fig. 11 is a view for explaining a method of determining partial discharge of a T shaped metal tank according to Embodiment 3 of the present invention.

Fig. 12 is a view showing another example for explaining a method of determining partial discharge of the T shaped metal tank according to Embodiment 3 of the present invention.

Fig. 13 is a view showing other example for explaining a method of determining partial discharge of the T shaped metal tank according to Embodiment 3 of the present invention.

Fig. 14 is a view showing a further other example for explaining a method of determining partial discharge of the T shaped metal tank according to Embodiment 3 of the present invention.

Fig. 15 is a sectional view of an insulating spacer part according to Embodiment 5 of the present invention.

Fig. 16 is a view showing a system for determining partial discharge according to Embodiment 6 of the present invention.

Fig. 17 is a view for explaining a method of determining partial discharge of a straight pipe metal tank according to Embodiment 6 of the present invention.

Fig. 18 is a sectional view of an insulating spacer part according to Embodiment 7 of the present invention.

DETAILED DESCRIPTION OF THE INVENTION

Embodiment 1.

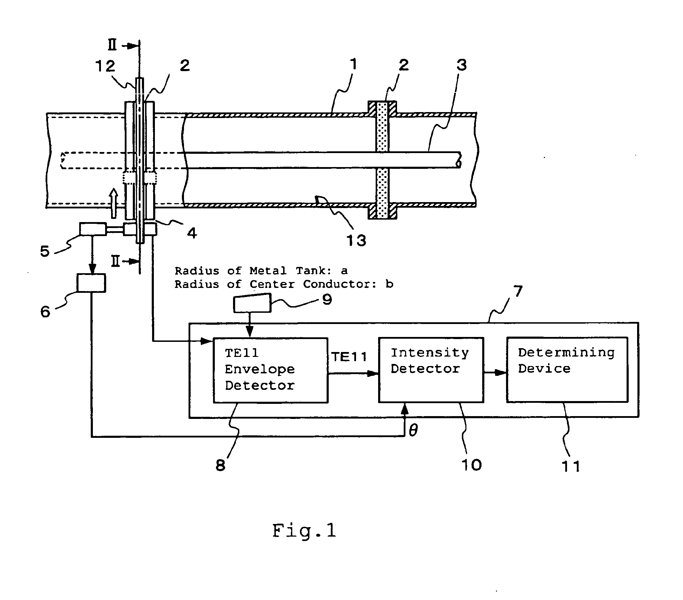

A system for determining partial discharge according to Embodiment 1 of the present invention will be described below with reference to the drawings. Fig. 1 is a view in which a system for determining partial discharge according to Embodiment 1 of the present invention is mounted on gas-insulated equipment. As an example of the gas-insulated equipment to be observed for determination, GIS (Gas Insulated Switchgear) will be described. GIS is configured so that it includes switchgear such as a disconnecting switch, a circuit breaker, and electrical equipment for protecting them, which are connected by bus lines, and a high voltage live part of each piece of equipment is accommodated in a metal tank filled with insulating gas. The Figure shows a case where the system for determining partial discharge is disposed in a bus line tank part of the GIS.

As shown in the Figure, the system is configured such that a plurality of cylindrically shaped metal tanks 1 are coupled via insulating spacers 2 and a cylindrical center conductor 3 supported by the insulating spacers 2 is coaxially disposed. Then, insulating gas is filled in the metal tank 1 partitioned by the insulating spacers 2.

Next, the configuration of the system for determining partial discharge will be described. An electromagnetic wave detector 4 for detecting an electromagnetic wave signal which propagates in the metal tank 1 is disposed on an outer circumferential part of the insulating spacer 2 which couples the metal tank 1. The electromagnetic wave detector 4 is mainly formed of an electromagnetic wave antenna, for example, a loop coil, a dipole antenna, a log periodic antenna, a horn antenna or the like. The electromagnetic wave detector 4 is movable along the outer circumferential direction of the insulating spacer 2 by a moving device 5, and an electromagnetic wave can be measured at any position in the outer circumferential direction to detect it. Position information of the electromagnetic wave detector 4 when the electromagnetic wave detector 4 is moved along the outer circumferential direction of the insulating spacer 2 by the moving device 5 is sent to a displacement angle detector 6 to be detected as a displacement angle $\theta$ from a reference point.

A detection signal from the electromagnetic wave detector 4 and displacement angle information from the displacement angle detector 6 are transmitted to a determining section 7. The determining section 7 includes a TE11 envelope detector 8 for extracting the electromagnetic wave signal of a frequency band in which a TE11 mode propagates but a TE21 mode does not propagate by utilizing a cutoff frequency, to be described later, from a detection signal of the electromagnetic wave detector 4; an input section 9 for inputting outer diameter information of the metal tank 1 and the center conductor 3 necessary for computing the cutoff frequency; an intensity detector 10 for detecting an intensity distribution of electromagnetic waves in the outer circumferential direction of the metal tank 1 by receiving an output signal from the TE11 envelope detector 8 and the displacement angle $\theta$ of the displacement angle detector 6; and a determining device 11 for determining the presence or absence of a partial discharge by comparing the detected intensity distribution with an intensity distribution peculiar to the TE11 mode. The above-mentioned reference numerals 4 to 11 constitute essential parts of the system for determining partial discharge. In addition, for example, a foreign particle or the like in the tank may act as a partial discharge source 13.

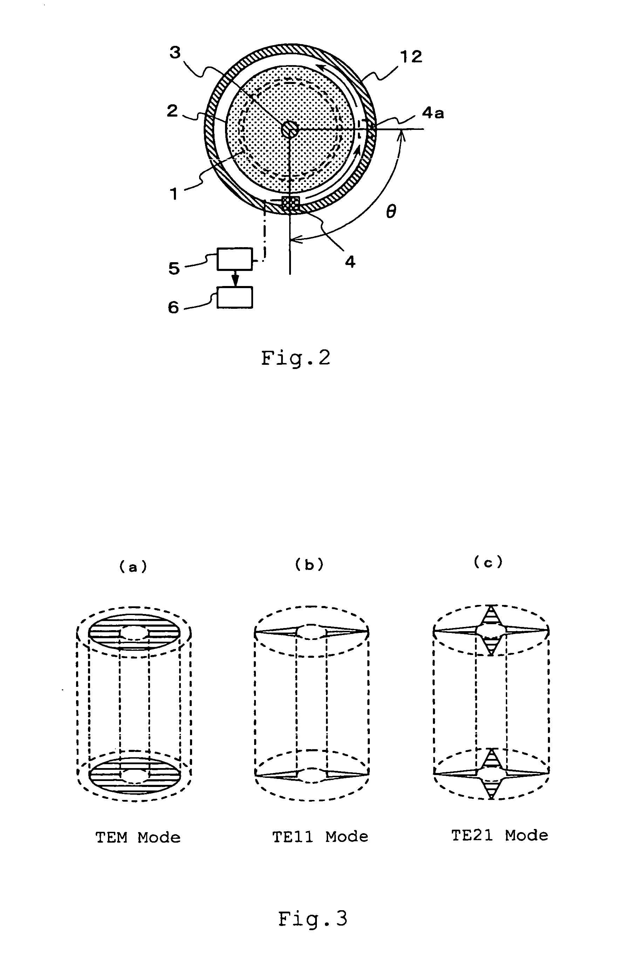

Fig. 2 is a cross-sectional view taken along the line II-II of Fig. 1 and shows an example when the electromagnetic wave detector 4 is made to move by the moving device 5. As shown in the Figure, a guiding rail 12 is provided on the outer circumferential part of the insulating spacer 2 so as to slidably engage the guiding rail 12 with an engaging part provided on the electromagnetic wave detector 4. A drive motor is provided on the electromagnetic wave detector 4 so as to move on the guiding rail 12 by a command from the moving device 5. The position information in the circumferential direction at this time is extracted to the displacement angle detector 6. For example, if the position of the perpendicular bottom part of the Figure is the reference point, $\theta$ is detected as the displacement angle when measurement is performed at a position 4a.

In addition, the moving device shown in Fig. 2 is an example, and it is not limited to the configuration shown in the Figure so long as it can move in the outer circumferential direction of the insulating spacer 2.

Next, a method for detecting partial discharge by the system for determining partial discharge of the present invention will be described. The bus line tank of the GIS, as shown in Fig. 1, is of a coaxial structure composed of the center conductor 3 and the metal tank 1 which surrounds it. An electromagnetic wave mode which propagates in such a coaxial structure includes a TEM mode, a TE mode (TE11, TE21, TE31...), and a TM mode; each mode represents a different propagation form of electromagnetic waves and is distinguished by the presence or absence of electric field and magnetic field vector with respect to the direction of propagation. It is known that the TEM, TE11 mode, TE21 mode... exist in limited areas not lower than a specific frequency for each mode. Such a specific frequency is a so-called cutoff frequency and is determined according to the shape and size of configuration elements, such as the center conductor diameter, the tank diameter, or the like, that is, according to the shape and size of the gas-insulated equipment. For example, when the radius of the metal tank 1 is a, the radius of the center conductor 3 is b, and the velocity of light is c, the cutoff frequency f of the TEm1 mode is approximately represented by Equation 1.

$$f = c * m / [(\pi (a + b)] \qquad ........\text{Equation 1}$$

where m = 1, 2, 3 ...
In other words, if the shapes of the metal tank 1 and the center conductor 3 are determined, an existing mode and the cutoff frequency can be specified.

Of the respective modes, the TEM mode is an electric field distribution that is the same as a static electric field that has no peak distribution in the circumferential direction of the tank. On the other hand, the TE(m1) mode denotes the electric field distribution that has a peak distribution in the circumferential direction. Fig. 3 is a typical view showing the electromagnetic field distribution of the TEM mode, the TE11 mode, and the TE21 mode in a coaxial line. As shown in the Figure, the TE11 mode denotes an electric field distribution having strong peaks at circumferential positions of 180° symmetry; the TE21 mode denotes an electric field distribution having peaks at circumferential positions of 90° symmetry.

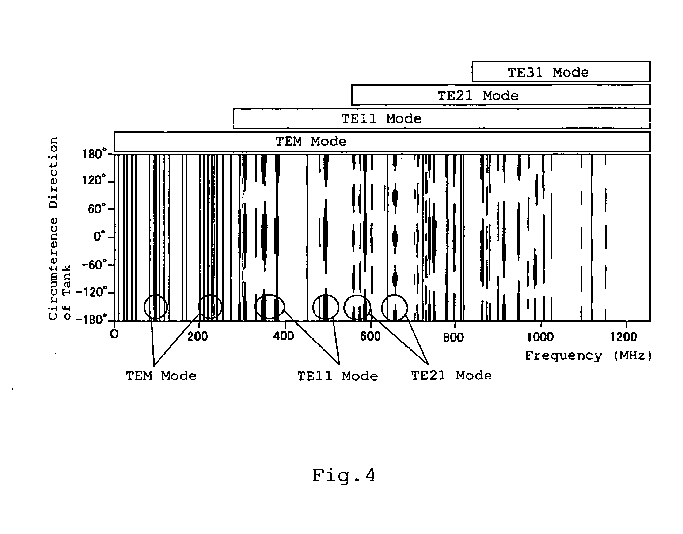

Fig. 4 is a view showing an example of the intensity distribution of an electromagnetic wave when a partial discharge occurs in the metal tank. The contrast between the electromagnetic wave intensity of each frequency and the distribution state in the wall surface of the metal tank is represented in shading. This Figure is an example of experimental validation data cleared by investigation by the inventors, which shows a partial discharge generated in a metal tank with a 2 m long center conductor. The vertical axis shows the outer circumferential position on the metal tank as an angle by defining the discharge source as a reference point (0°), and the horizontal axis shows frequency (MHz). In the Figure, parts in deep shade represent strong parts of the electromagnetic wave signal. Above the Figure, a frequency band in which each electromagnetic wave signal of the TEM mode, TE11 mode, TE21 mode, and TE31 mode propagates is shown by a horizontal bar chart.

As illustrated by circles in the Figure, it is well known that the TEM mode has signals uniformly in the circumferential direction without having a peak value; the TE11 mode has two strong peaks at the 180° opposing positions in the circumferential direction; and the TE21 mode has four peaks at intervals of 90°. Therefore, if such an intensity distribution is verified in the frequency region of each mode computed by using Equation 1, it indicates that there is absolutely an electromagnetic wave of its mode.

As described above, electromagnetic waves due to partial discharge are broadly distributed in the GIS from the TEM region to that of mode signals of a higher order. It becomes possible to determine the presence or absence of a partial discharge in the GIS by obtaining the distribution shape. Here, a mode to be focused on needs to be determined by taking account of the ease of distinguishing the pattern and the ease of processing the signal. Regarding the ease of processing the signal, although it is preferable to select a lower frequency band as a detection target, it is difficult to find a characteristic distribution pattern because the TEM mode existing at the lowest frequency is distributed in all circumferential directions. On the other hand, in the case of a higher order mode, since the shape of the distribution is complicated, it is possible to find a pattern peculiar to the GIS which does not exist in nature; however, if it is too complicated, the determining algorithm for the system for determining partial discharge becomes very sophisticated and complicated and processing of a high frequency signal also becomes difficult; thus it is not suitable for actual diagnosis. Therefore, this embodiment focuses on the TE11 mode, in which a feature relatively peculiar to the GIS can be found, and an area in which signal processing is easy. In addition, the frequency band of the TE11 mode for an actual GIS tank according to a trial calculation using Equation 1 is approximately 200 MHz to 1 GHz, though it differs according to the tank diameter.

The frequency band, which is previously described in that the electromagnetic wave signal of the frequency band in which the TE11 mode propagates but the TE21 mode does not propagate is extracted using by the TE11 envelope detector 8 of Fig. 1, has a range not lower than the cutoff frequency of the TE11 mode calculated according to Equation 1 and less than the cutoff frequency of the TE21 mode. In this regard, Equation 1 is an approximate equation and the mode cannot be completely distinguished by this equation, and therefore, the range need not to be strictly delimited and some tolerance may be provided at the front and back. For actual usage, it is practical to have some tolerance from the view point of versatility.

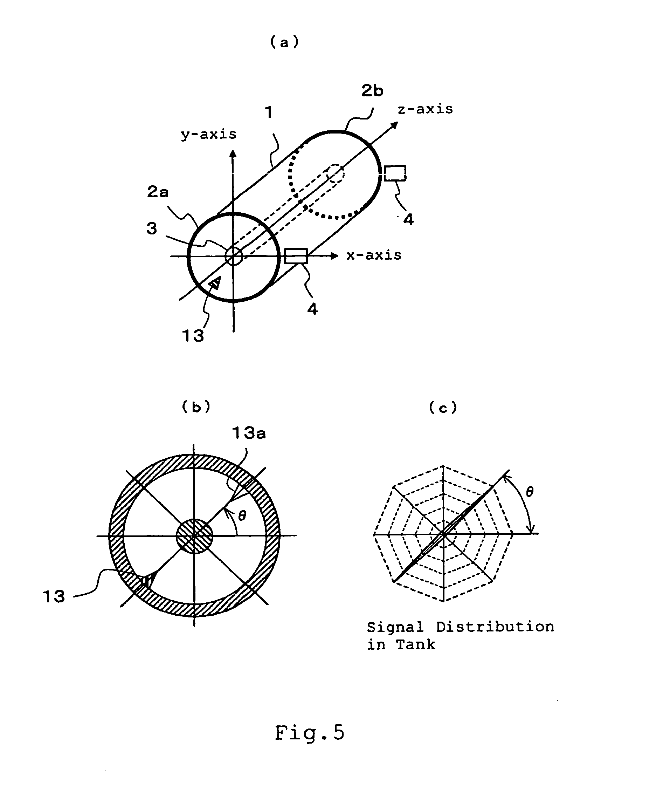

Next, a specific determining method in the gas-insulated equipment will be described. Fig. 5 is a view for explaining a method of determining partial discharge using the system for determining partial discharge of the present invention. Fig. 5(a) shows an occurrence position when a partial discharge occurs in the metal tank 1 formed of a straight pipe, which is partitioned by two insulating spacers 2a and 2b; Fig. 5(b) is a cross-sectional view in a direction perpendicular to the z-axis of the occurrence position of the partial discharge and shows the case where the partial discharge source 13 exists at a position at an angle $\theta$ when the horizontal direction is set as a reference, for example. Further, Fig. 5(c) shows the intensity distribution of an electromagnetic wave signal in the circumferential direction when the electromagnetic wave signal due to a partial discharge is observed at the insulating spacers 2a or 2b provided at connection parts of the straight pipe metal tank 1.

In addition, the partial discharge source 13 is shown adjacent to the insulating spacer for the sake of facilitating understanding, but it may be placed at any location in the metal tank 1. Further, the intensity distribution of an electromagnetic wave signal is shown by simplifying in order to clearly visually describe the direction and shape that the peak mainly takes, and therefore, it does not correctly represent the actual measurement value. The description of the following embodiment is also similar to the above description.

Measurement of partial discharge is performed at a plurality of circumferential positions while the electromagnetic wave detector 4 is moved by the moving device 5 along the circumferential direction of the insulating spacer 2a. At this time, information of the measurement position from the reference point is detected by the displacement angle detector 6 as angle information $\theta$, and it is transmitted to the determining section 7 of the system for determining partial discharge.

When the partial discharge source 13 generated in the GIS tank exists, for example, at the position at the angle θ when the horizontal direction is set as the reference (13a opposing 13 by 180° is also the same), the electromagnetic wave signal is also strongly radiated in the direction of the angle θ; thus, in the insulating spacer 2a, a distribution having a strong peak signal at substantially the angle θ is confirmed as shown in Fig. 5(c).

Consequently, if the electromagnetic wave signal from the electromagnetic wave detector 4, measured at a plurality of outer circumferential positions of the insulating spacer 2a, is extracted to the determining section 7 of the system for determining partial discharge as shown in Fig. 1, to represent a circumferential intensity distribution by performing signal processing, a strong peak value is found at the position opposing by substantially 180° when electromagnetic waves of the TE11 mode exist, that is, when the electromagnetic waves are due to partial discharge. Therefore, the presence or absence of a partial discharge can be determined depending on whether or not the intensity distribution of the detected result is indicative of a distribution peculiar to the TE11 mode.

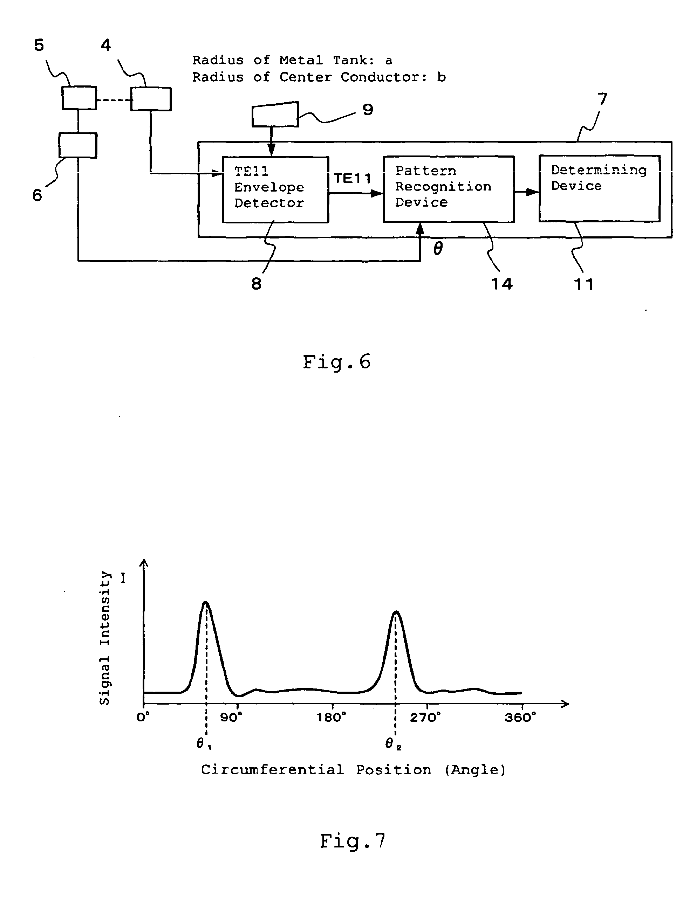

A pattern recognition device, which is used as a specific example of the intensity detector 10, will be described. Fig. 6 is a block diagram when a pattern recognition device 14 is used as the intensity detector of the system for determining partial discharge. Since those other than the pattern recognition device 14 are the same as in Fig. 1 and their description will not be repeated. When a TE11 signal from the TE11 envelope detector 8 and information of the displacement angle θ from the displacement angle detector 6 are inputted to the pattern recognition device 14, the pattern recognition device 14 generates an intensity distribution pattern of the electromagnetic wave signal on the outer circumference of the insulating spacer 2. An example of the intensity distribution pattern is shown in Fig. 7. The vertical axis of the Figure is the signal intensity, the horizontal axis is the circumferential position (angle), and the signal intensity at each position is graphed, resulting in an intensity distribution pattern shown by the thick line. The determining device 11 determines, for example, whether or not a mode is peculiar to the TE11 mode from the interval between $\theta_1$ and $\theta_2$ and the peak value. If remarkable peak values such as $\theta_1$ and $\theta_2$ are confirmed at positions substantially opposing each other by 180°, it can be determined that the distribution is peculiar to the TE11 mode, and therefore, it can be determined that the electromagnetic waves due to partial discharge are detected. As described, in the measurement in the outer circumferential direction of the insulating spacer 2, it can be specified that there is no external noise but there exists a partial discharge inside by confirming, in a reproducible fashion, that two peaks exist at positions spaced by substantially 180°.

In addition, the pattern recognition device can use various kinds of signal processing techniques generally available at present.

Further, as shown in Fig. 5 (a), in the case where the insulating spacer 2a and the insulating spacer 2b are disposed at both ends of the metal tank 1, when the partial discharge source 13 exists in the insulated compartment, a distribution shape having two peaks, like that described above, propagates to both sides without losing its shape if a straight pipe metal tank is used; and therefore, the peak values appear at the same positions of the adjacent insulating spacers 2a and 2b.

Consequently, in the case where two or more insulating spacers exist in the straight pipe metal tank 1, when a signal of the TE11 mode having peaks at positions of 180° symmetry in the circumferential direction is detected and the peak values are confirmed at the same positions in the adjacent insulating spacer 2b, the signal detected by the electromagnetic wave detector 4 can be determined as a partial discharge signal in the metal tank 1. When the both peak positions are different, the signal is not being due to a partial discharge, but determined as external noise.

Further, as described above, the peak signal appears in the same direction as the circumferential position of the partial discharge source 13. By using this fact, the circumferential position of the partial discharge source 13 can be estimated by position (angle) information of the circumferential position of the metal tank 1 at which the detected peak signal appears. In this regard, in Fig. 5(b), it cannot be determined whether the partial discharge source appears at 13 or 13a, nor whether it appears at the metal tank 1 side or the center conductor 3 side.

The description so far concerns the case where, as a method of measuring at a plurality of outer circumferential positions of the insulating spacer 2 using the electromagnetic wave detector 4, the measurement position is moved by using the moving device 5. However, for example, a measurement operator may measure while moving the electromagnetic wave detector 4 along the outer circumferential direction of the insulating spacer 2 without depending on the moving device 5. Further, the position (angle) information need not be automatically extracted from the displacement angle detector 6; the measurement operator may input the information to the intensity detector 10.

Further, the electromagnetic wave detector 4 need not be made to move, a plurality of electromagnetic wave detectors 4 may be disposed by fixing them at outer circumferential predetermined positions of the insulating spacer 2.

Further, in order to compute the cutoff frequency, diameter information of the metal tank 1 and the center conductor 3 is inputted from the input section 9. However, the information need not be inputted in each case; it may be stored in advance in a memory unit, or a cutoff frequency computed from diameter information may be directly used when the gas-insulated equipment to be measured is specified.

Furthermore, when the presence or absence of a partial discharge is determined from the measurement result, at the stage where the intensity distribution is obtained by the intensity detector, it is possible, for a person of skill in the art, to determine the presence or absence of a partial discharge by observing the intensity distribution without using the determining device at a subsequent stage. For example, if the pattern recognition device described above is used as the intensity detector and the result is displayed visually as the intensity distribution pattern, the presence of the TE11 mode can be confirmed from the Figure. Therefore, the determining device 11 in the determining section 7 is not required as the system for determining partial discharge.

As described above, according to this embodiment of the present invention, it performs: detecting an electromagnetic wave signal at a plurality of outer circumferential positions of an insulating spacer; extracting a signal of a frequency band in which a TE11 mode propagates but a TE21 mode does not propagate with a TE11 envelope detector; detecting an intensity distribution of an outer circumferential electromagnetic waves in a metal tank from the intensity of the extracted signal and the circumferential position information of an electromagnetic wave detector; and determining the presence or absence of a partial discharge depending on whether or not the intensity distribution is indicative of a distribution peculiar to the TE11 mode, and therefore, a signal of the TE 11 mode included in an electromagnetic wave caused by a partial discharge can be effectively captured and a feature peculiar to the mode can be extracted, thereby enabling the provision of a method of determining partial discharge or a system for determining partial discharge which can determine the presence or absence of a partial discharge with high reliability, without being affected by external noise.

Further, determination of the presence or absence of a partial discharge is performed by comparing the intensity distribution of the electromagnetic wave obtained by the intensity detector using the determining device with a distribution peculiar to the TE11 mode, and therefore, more accurate determination can be performed in addition to the above-mentioned effects.

Further, detection of the electromagnetic waves is performed while the electromagnetic wave detector is moved along the outer circumferential direction of the insulating spacer by the moving device to perform measurement; therefore, a measurement position can be freely selected and the measurement can be effectively performed.

Further, detection of the above-mentioned electromagnetic waves is performed by the electromagnetic wave detectors disposed at a plurality of outer circumferential positions of the insulating spacer; therefore, it is possible to save the trouble of determining the measurement positions and to reliably perform measurement without neglecting to set the measuring points.

Further, the pattern recognition device is used as the intensity detector, and therefore, the presence or absence of a partial discharge can be visually determined.

Further, a peripheral position where the output reaches a peak is specified, and the location of a partial discharge source in the circumferential direction of the metal tank is estimated from the specified outer circumferential position; therefore, it is possible to determine whether the partial discharge source is located at the bottom surface of the tank or is stuck to the side surface, even in gas-insulated equipment whose inside cannot be easily seen, like a GIS.

Further, the cutoff frequency is computed by inputting values of a diameter of the metal tank and the diameter of the center conductor and a frequency band to be detected by the TE11 envelope detector is set; therefore, a frequency band of the TE11 mode which is compatible with the gas-insulated equipment to be measured can be accurately determined.

Furthermore, intensity distributions of electromagnetic waves, respectively measured at two insulating spacers mounted in the axial direction of a straight pipe metal tank, are compared to determine that a partial discharge occurs in the straight pipe if peak positions of both intensity distributions are the same; therefore, the presence or absence of a partial discharge in the straight pipe tank can be accurately determined.

Embodiment 2.

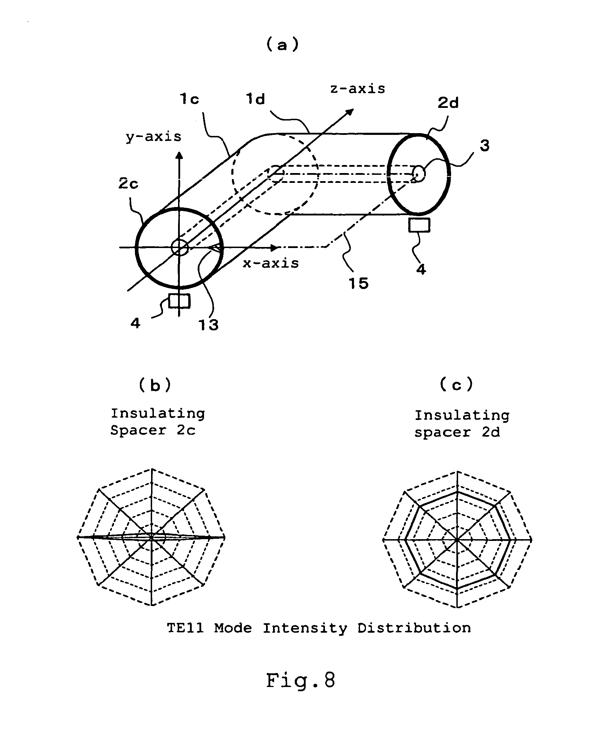

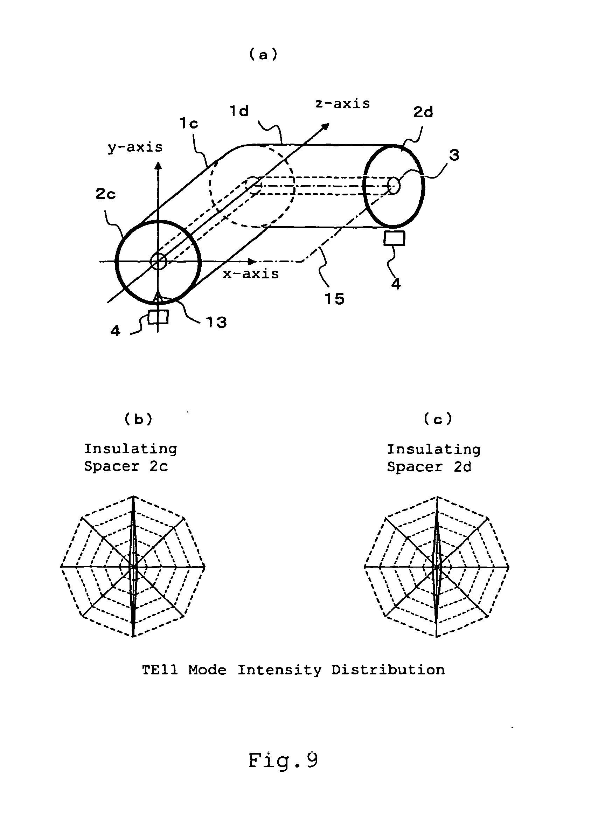

Fig. 8 to Fig. 10 are a view for explaining a method of determining partial discharge according to Embodiment 2 of the present invention. Fig. 8(a) and Fig. 9(a) show occurrence positions where partial discharges in an L shaped metal tank; Fig.8(b) and Fig.9(b) show the intensity distributions of electromagnetic waves at an insulating spacer part at one side; and Fig. 8(c) and Fig. 9(c) show the intensity distributions of electromagnetic waves at an insulating spacer part at the other side. As shown in the Figures, insulating spacers 2c and 2d are respectively disposed behind and in front of an L shaped bent part with respect to L shaped metal tanks 1c and 1d. Since the configuration other than the L shaped metal tanks 1c and 1d is equivalent to Fig. 1 described in Embodiment 1 and the system for determining partial discharge is equivalent to the figures described in Embodiment 1, a detailed description thereof will not be repeated, and a description mainly about the points of difference will be given.

In the case where the GIS is configured by a straight pipe metal tank, the behavior of the electromagnetic waves is simple as described in Embodiment 1; however, since an actual GIS is configured by combining a plurality of L shaped or T shaped tanks, conversion of the electromagnetic wave mode occurs at the L shaped or T shaped bent parts, and the shape of circumferential distribution of the signal is lost.

First, as shown in Fig. 8, the case where a partial discharge source 13 exists in the metal tank 1c at the front side of the L shaped bent part will be described. In order to specify a direction in the Figure, a plane including axis lines of the metal tanks 1c and 1d is set as a reference plane 15. The case where the partial discharge source 13 is located on the metal tank 1c side at a position which passes through the axis line in the direction (x-axis direction) parallel to the reference plane 16 will be described.

In this case, in the insulating spacer 2c, the intensity distribution of the TE11 mode having a peak value in the direction (x-axis direction) parallel to the reference plane 15, like Fig: 8(b), is confirmed. Then, it has been confirmed by investigation by the inventors that, in the insulating spacer 2d after passing the L shaped part, the intensity distribution appeared in the all circumferential directions, as shown in Fig. 8(c), unlike the distribution in 2c.

As a result, in the case where the insulating spacers 2c and 2d exist behind and in front of the bent part of the L shaped metal tank, when the electromagnetic wave intensity distribution of the TE11 mode is measured with the electromagnetic wave detector 4 at both insulating spacers 2c and 2d, and two peak values exist in the direction substantially parallel to the reference plane 15 at the insulating spacer 2c on one side, it can be determined that a partial discharge, not external noise, occurs in the metal tank if it can be confirmed that the distribution reproducibly exists in all circumferential directions at the insulating spacer 2d on the other side.

Next is the case where the partial discharge source 13 is located in the metal tank 1 c at a position which passes through the axis line in the direction (y-axis direction) perpendicular to the reference plane 15, as shown in Fig. 9 which is of the L shaped metal tank similar to Fig. 8 shown in Fig. 9(a). At this time, the electromagnetic waves of the TE11 mode due to the partial discharge measured at the insulating spacer 2c have peak values in the direction (y-axis direction) perpendicular to the reference plane 15, as shown in Fig. 9(b); as shown in Fig. 9(c), a signal distribution having peak values in the direction perpendicular to the reference plane 15 is confirmed, even in a signal observed at the insulating spacer 2d after passing the L shaped bent part.

From this result, in the case where the insulating spacers 2c and 2d exist on both sides of the L shaped metal tank 1c and 1d, when the electromagnetic wave circumferential intensity distribution of the TE11 mode is measured with the electromagnetic wave detector 4 at both the insulating spacer parts, and two peak values exist in the direction substantially perpendicular to the reference plane 15 at the insulating spacer 2c on one side, it can be determined that a partial discharge occurs in the metal tank if it can be confirmed that, similarly, two peak values reproducibly exist in the perpendicular direction at the insulating spacer 2d on the other side.

The description so far is of the case where the partial discharge signal enters in the direction parallel or perpendicular to the reference plane 15. Next, the case where the partial discharge source 13 is located in a direction oblique to the reference plane 15 will be described. It is confirmed that, in the case where the signal enters in an oblique direction, the oblique signal is considered to be separated into a horizontal component and a vertical component and this will be described next.

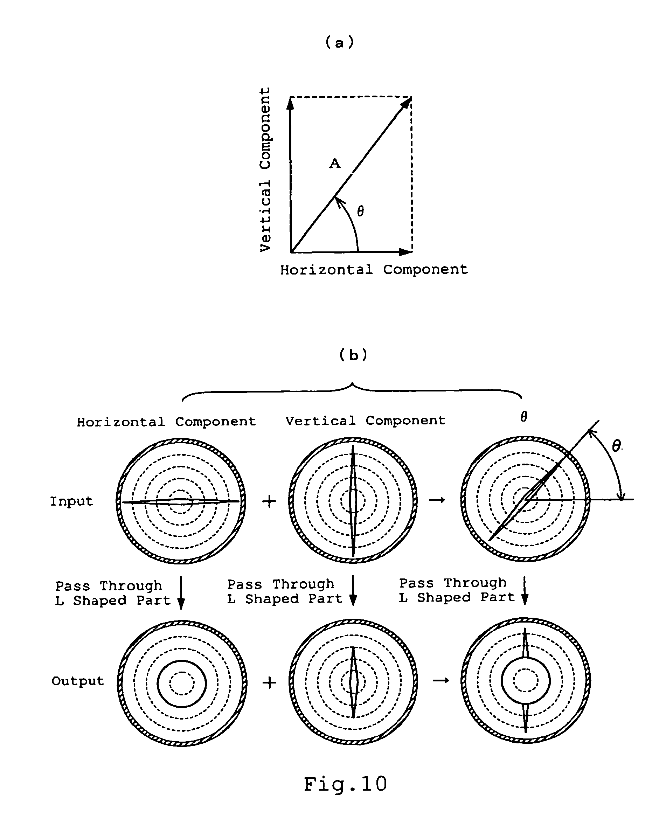

Fig. 10 is a view for explaining the variation of the TE11 mode electromagnetic wave distribution at the L shaped bent part when the partial discharge source 13 exists in a direction oblique to the reference plane. As shown in Fig. 10(a), in the case where the partial discharge source 13 exists at a position of an angle $\theta$ with reference to a horizontal direction (the reference plane), a distribution having strong signal peaks is confirmed that the partial discharge source 13 exists at a position of the angle $\theta$ as the sum of the horizontal component and the vertical component at the insulating spacer 2c of the metal tank 1c side, as shown by "input" in Fig. 10(b). This can be considered as a result of the sum of the horizontal component ($A \cos\theta$) and the vertical component ($A \sin\theta$) into which the signal having amplitude A, entering at angle $\theta$, is divided. On the other hand, at the insulating spacer 2d side after passing the L shaped bent part, as shown by "output" in Fig. 10(b), it is confirmed that a distribution like a bottom right mode, which is the sum of the result converted at respective bent parts of the horizontal component and the vertical component, appeared.

Consequently, in the actual measurement, in the case where circumferential distribution of the signal observed at the insulating spacers behind and in front of the L shaped bent part conforms to the distribution predicted here; that is, when an intensity distribution having two peak values in the oblique direction at the insulating spacer part on one side is confirmed, and an intensity distribution corresponding to the sum of the vertical direction component and the entire circumferential direction component is confirmed at the insulating spacer part on the other side, it can be determined that a partial discharge occurs in the metal tank.

As described above, according to this embodiment of the present invention, it includes a metal tank having an L shaped bent part, in the case where metal tanks extending in two directions from the bent part are respectively provided with insulating spacers, when a plane including axis lines of the L shaped metal tank is defined as a reference plane, it is determined such that a partial discharge occurs in the L shaped metal tank in the case where an intensity distribution having two peak values in a direction substantially parallel to the reference plane at one insulating spacer part is confirmed and an intensity distribution having signals in the entire circumference at the other insulating spacer part is confirmed; and therefore, the presence or absence of a partial discharge occurred at a position parallel to the reference plane in the inner circumferential direction of the L shaped metal tank can be accurately determined.

Further, it is determined such that a partial discharge occurs in the L shaped metal tank in the case where an intensity distribution having two peak values in a direction substantially perpendicular to the reference plane at the one insulating spacer part of the L shape is confirmed and an intensity distribution also having peak values in the similar direction at the other insulating spacer part is confirmed; and therefore, the presence or absence of a partial discharge occurred at a position perpendicular to the reference plane in the inner circumferential direction of the L shaped metal tank can be accurately determined.

Further, it is determined such that a partial discharge occurs in the L shaped metal tank in the case where an intensity distribution having two peak values in a direction substantially oblique with respect to the reference plane at one insulating spacer part of the L shape is confirmed and an intensity distribution corresponding to a sum of a perpendicular direction component with respect to the reference plane and all circumferential direction components at the other insulating spacer part is confirmed; and therefore, the presence or absence of a partial discharge occurred at a position oblique with respect to the reference plane in the inner circumferential direction of the L shaped metal tank can be accurately determined.

Embodiment 3.

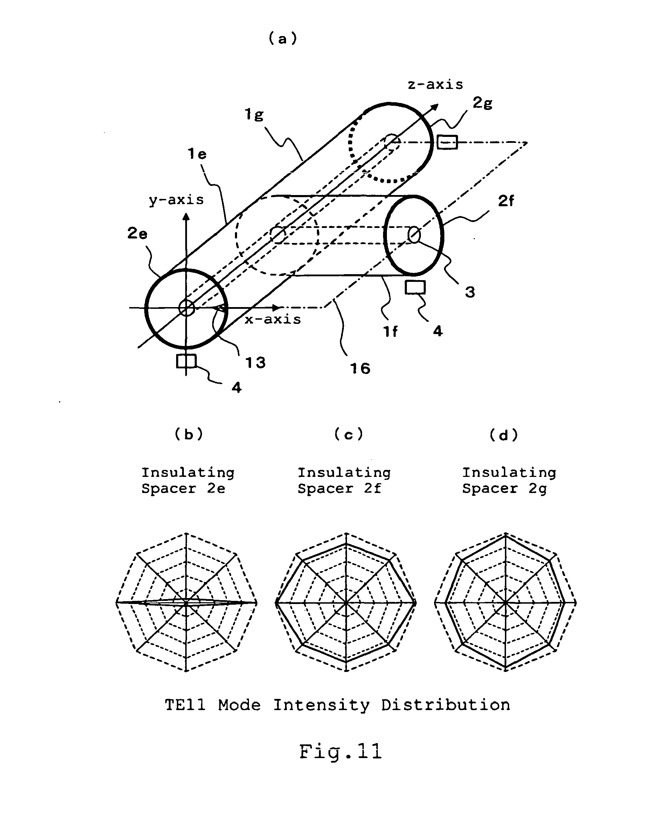

Fig. 11 to Fig. 14 are a view for explaining a method of determining partial discharge according to Embodiment 3 of the present invention. (a) of the Figures show occurrence positions where partial discharges in an T shaped metal tank; and (b) to (d) show the intensity distributions of electromagnetic waves at each insulating spacer part. As shown in the Figures, the T shaped metal tank has a straight pipe part and a branch pipe part which is branched in a T shape in the middle of the straight pipe part and the metal tanks 1e, 1f, and 1g extending in three directions from the branched points are respectively provided with insulating spacers 2e, 2f, and 2g. Since the configuration other than the T shaped metal tank is equivalent to Fig. 1 described in Embodiment 1 and the system for determining partial discharge is equivalent to the figures described in Embodiment 1, a detailed description thereof will not be repeated, and a description mainly about the points of difference will be given.

In order to specify a direction in the Figure, a plane including axis lines of the metal tanks 1e to 1 g is set as a reference plane 16. First, as shown in Fig. 11, the case where the partial discharge source 13 is located on the metal tank 1e side at a position which passes through the tank axis line in a direction parallel to the reference plane 16 will be described. In the case where the partial discharge source 13 exists at a position as shown in the Figure, the signal distribution of the TE11 mode having two peaks in the direction (x-axis direction) parallel to the reference plane 16 at the insulating spacer 2e as shown in (b) is confirmed. At this time, it is noted that, in the insulating spacer 2f on the branch pipe 1f side and the insulating spacer 2g on the straight pipe 1g side after passing the branched part, the intensity distribution appear in all circumferential directions, as shown in (c) and (d) of the figure, unlike the distribution in 2e. In addition, the case where the partial discharge source 13 is located in the same direction on the straight pipe 1g side is also similar.

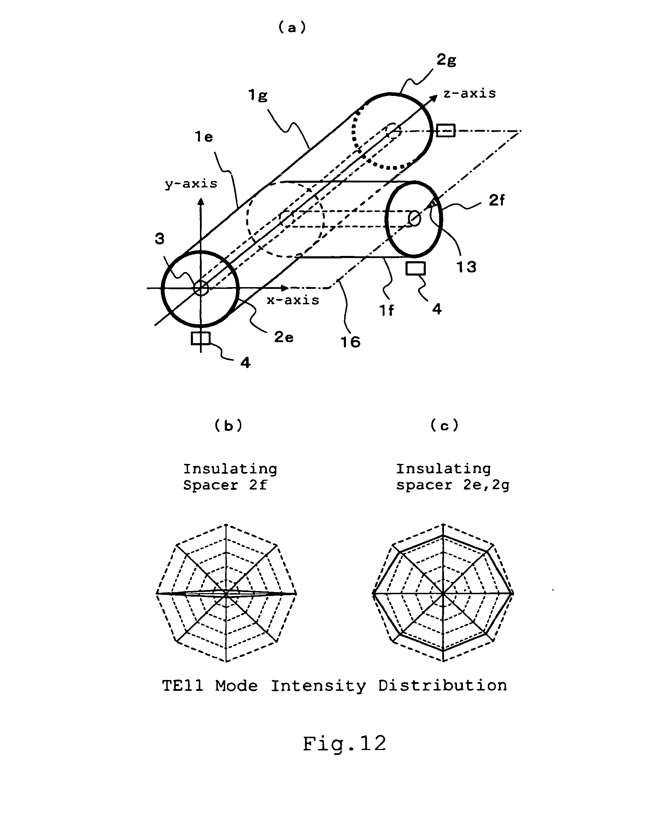

On the other hand, as shown in Fig. 12 (a), it is noted that when the partial discharge source 13 exists in the branch pipe 1f side at a position which passes through the axis line in a direction (z-axis direction) parallel to the reference plane 16, the distribution having two peak values parallel to the reference plane is confirmed at the insulating spacer 2f as shown in (b); in the insulating spacer 2e on the straight pipe le side and the insulating spacer 2g on the straight pipe 1g side after passing the branched part, the intensity distributions which have signals on the entire circumference in the circumferential direction appear, as shown in (c).

As a result, in the case where the T shaped metal tank is provided with insulating spacers on both sides of the straight pipe part and on the branch pipe side, and when the electromagnetic waves are detected with the electromagnetic wave detector 4 at the respective insulating spacers 2e to 2g to detect the frequency of the TE11 mode, which is deemed as the intensity distribution in the circumferential direction of the tank; it can be determined that a partial discharge occurs in the metal tank in the case where an intensity distribution having two peak values in a direction substantially parallel to the reference plane 16 at any one of the insulating spacer parts is confirmed and an intensity distribution having signals in the entire circumference at the other two insulating spacer parts is confirmed.

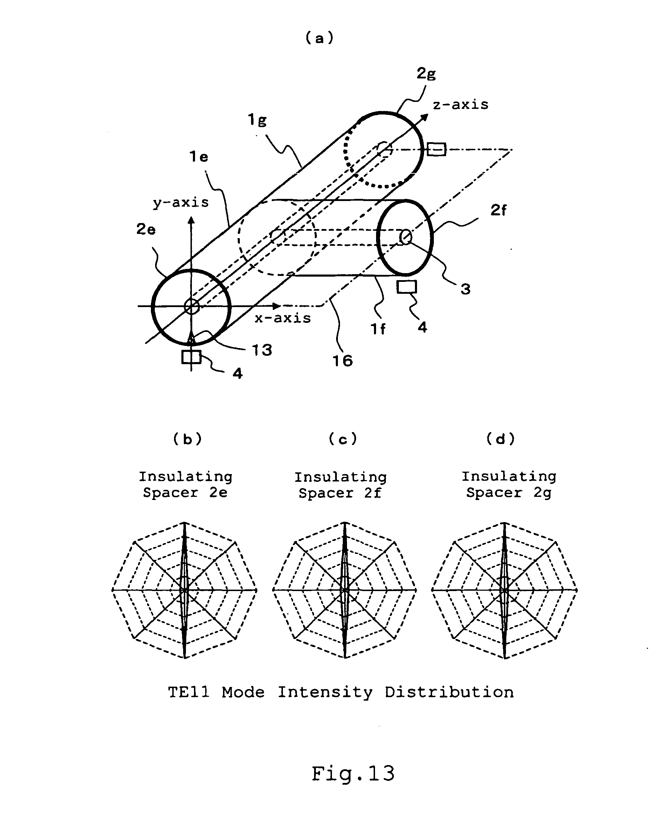

Next, the case where the partial discharge source 13 exists at a position which passes through the center of axis line of the tank in the direction (y-axis direction) perpendicular to the reference plane 16 will be described. This is the case where the partial discharge source 13 is located in the direction perpendicular to the reference plane 16 at the straight pipe 1e side of the T shaped metal tank as shown in Fig. 13(a). In this case, in the insulating spacer 2e on the metal tank 1e side at which the partial discharge source 13 exists, the electromagnetic waves of the TE11 mode due to the partial discharge have two peak values in the direction perpendicular to the reference plane 16, as shown in (b); further, as shown in (c) and (d), it is confirmed that the electromagnetic wave signals have the intensity distribution having two peak values in the direction perpendicular to the reference plane 16, even in the case of the insulating spacer 2f on the branch pipe 1f side and the insulating spacer 2g on the straight pipe 1g side after passing the branched part.

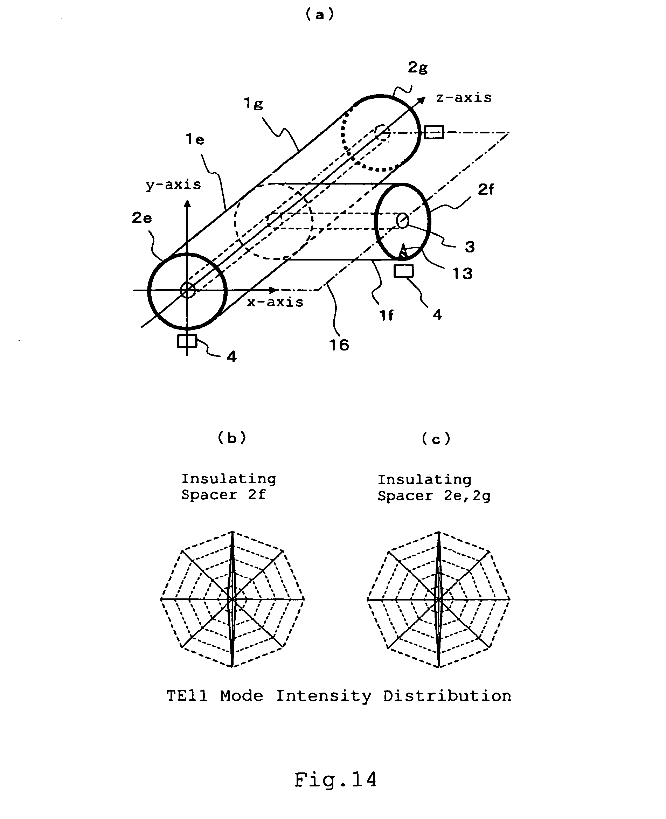

Similarly, as shown in Fig. 14(a), the case where the partial discharge source 13 exists at a position which passes through the axis center on the branch pipe 1f side in the direction perpendicular to the reference plane 16 will be described. In the insulating spacer 2f on the metal tank side at which the partial discharge source 13 exists, the electromagnetic waves of the TE11 mode due to the partial discharge have two peak values in the direction perpendicular to the reference plane 16, as shown in (b); it is confirmed that the electromagnetic wave signal, observed at the insulating spacers 2e and 2g which are provided with the straight pipe 1e and 1g after passing the branched part, has an intensity distribution having two peak values in the direction perpendicular to the reference plane 16, as shown in (c).

From these results, in the case where the insulating spacers are provided in three directions of the T shaped metal tank; when the electromagnetic wave signal detected with the electromagnetic wave detector 4 at the respective insulating spacers 2e to 2g is processed to obtain the intensity distribution in the circumferential direction of the tank, and two peak values in the direction substantially perpendicular to the reference plane 16 at either one of the insulating spacer parts exist; it is determined that a partial discharge occurs in the tank by confirming that two peak values reproducibly exist in the direction substantially perpendicular to the reference plane 16 similarly at the other insulating spacer parts, that is, by confirming that two peak values appears in the direction substantially perpendicular to the reference plane 16 at all the insulating spacer parts.

For sake of simplicity, the description so far is of the case where the partial discharge source is located in the direction perpendicular or parallel to the reference plane 16. In the case where the partial discharge source exists in the direction oblique with respect to the reference plane 16, as in the case described in Embodiment 2, the intensity distribution of the TE11 mode can be obtained by dividing the oblique direction signal into a horizontal component and a vertical component and by superimposing each mode conversion result again. Although not shown in the Figure, in the case where the partial discharge source 13 is located in the direction oblique with respect to the reference plane 16, it can be verified that an intensity distribution having two peak values in a direction substantially oblique with respect to the reference plane 16 at any one of three insulating spacer parts is confirmed and an intensity distribution corresponding to the sum of all circumferential direction components and a perpendicular direction component at the other two insulating spacer parts is confirmed.

Therefore, in the actual measurement, when the electromagnetic waves are detected with the electromagnetic wave detector 4 at each insulating spacer part of the T shaped metal tank, the intensity distribution of the electromagnetic wave of the TE11 mode in the outer circumferential direction of each insulating spacer part is obtained by signal processing, and its result represents the intensity distribution as described above; it can be determined that a partial discharge occurs in the metal tank and those other than that are external noise.

As described above, according to this embodiment of the present invention, in a T shaped metal tank, when a plane including axis lines of the metal tank is defined as a reference plane, it is determined such that a partial discharge occurs in the case where an intensity distribution having two peak values in a direction substantially parallel to the reference plane at any one of three insulating spacer parts is confirmed and an intensity distribution having signals in the entire circumference at the other two insulating spacer parts is confirmed; and therefore, the presence or absence of a partial discharge occurred at a position parallel to the reference plane in the inner circumferential direction of the T shaped metal tank can be accurately determined.

Further, it is determined such that a partial discharge occurs in the case where an intensity distribution having peak values in a direction substantially perpendicular to the reference plane at all three insulating spacer parts; and therefore, the presence or absence of a partial discharge occurred at a position perpendicular to the reference plane in the inner circumferential direction of the T shaped metal tank can be accurately determined.

Furthermore, it is determined such that a partial discharge occurs in the case where an intensity distribution having peak values in a direction substantially oblique with respect to the reference plane at any one of three insulating spacers is confirmed and an intensity distribution corresponding to the sum of all circumferential direction components and a perpendicular direction component at the other two insulating spacer parts is confirmed; and therefore, the presence or absence of a partial discharge occurred at a position oblique with respect to the reference plane in the inner circumferential direction of the T shaped metal tank can be accurately determined.

Embodiment 4.

Next, a method of determining partial discharge according to Embodiment 4 will be described. Since a system for determining partial discharge itself is equivalent to Fig. 1 described in Embodiment 1, a detailed description thereof will not be repeated, and a description mainly about points of difference will be given. The metal tank of the gas-insulated equipment to be measured may be of either the straight pipe, L shaped configuration, or T shaped configuration. This embodiment specifically relates to a measurement point of an electromagnetic wave detector.

In the case where, for example, GIS is to be measured as the gas-insulated equipment, the number of the insulating spacers used in the GIS has several tens of units to several hundreds of units per one equipment, and therefore, much time and man power are required to measure all points of the units in the entire circumference. Consequently, it is necessary to make measurement more efficient.

In the case of detecting electromagnetic waves, propagating in a metal tank, in the outer circumferential direction of an insulating spacer with the electromagnetic wave detector, there are a method for continuously measuring in the circumferential direction and a method for measuring at the predetermined pitch. In view of a number of measuring points as described above, as a result of examining efficient measurement methods, it is realized that measurement point in which the circumference is divided into 8 parts is sufficiently practical when detecting it in all outer circumference of the insulating spacer. That is, it can be examined that an intensity distribution in the circumferential direction can be obtained if the measurement is performed at 8 positions spaced by 45°in the outer circumferential direction.

Consequently, as one of the efficient measurement methods, measurement position for measuring in the outer circumferential direction of the insulating spacer with the electromagnetic wave detector is to set at 8 positions evenly spaced in the outer circumferential direction of the insulating spacer. It follows that the intensity distribution can be more reliably obtained if the measurement is performed at 8 divided positions or more.

Furthermore, a more efficient measurement method will be described. As described in the embodiments so far, it is noted that, the intensity distribution of electromagnetic waves of the TE11 mode observed at the insulating spacer part is of point symmetry on the basis of the circle center point when the insulating spacer is seen from the circular direction. Focusing on this, when electromagnetic waves are measured with the electromagnetic wave detector at the outer circumference of the insulating spacer, the measurement is first performed in a half circumference, not the entire circumference. Then, the intensity distribution obtained by signal processing with the determining section is confirmed and only when the intensity distribution of the electromagnetic waves peculiar to the TE11 mode appears in this range, the remaining 1/2 is to be measured next.

The gas-insulated equipment, like a GIS, is used in electrical substation facilities, in which high reliability is required; and therefore, the equipment is produced under proper quality control and is controlled by maintenance management; thus, occurrence frequency of a partial discharge is actually very few. Consequently, in an actual field measurement, when measuring with the electromagnetic wave detector in the outer circumferential direction of the insulating spacer, the measurement is not suddenly performed on the entire circumference of all insulating spacers, but the measurement is first performed in a half circumference. Then, when the presence of the peak peculiar to the TE11 mode cannot be confirmed from the measurement of the half circumference, it means either a partial discharge is not generated or is unified by the mode conversion. In either case, it is meaningless to diagnose the partial discharge in detail at the insulating spacer part concerned. That is, only the insulating spacer, in which the predetermined intensity distribution can be confirmed, may be observed. If a partial discharge occurs in the metal tank, there certainly exists a insulating spacer showing the predetermined intensity distribution, and therefore, the sign can be seen even in the measurement of the half circumference. Consequently, only when the presence of the intensity distribution of electromagnetic waves peculiar to the TE11 mode is found at the measurement for the half circumference, the remaining 1/2 is measured. As a result, if the intensity distribution of the TE11 mode can be confirmed, determination is performed by the methods as described in Embodiment 1 to Embodiment 3 on the basis of the insulating spacer. Therefore, the measurement can be saved in half at an actual field measurement.

A further efficient measuring method will be described. As aforementioned, when the measurement is performed in the outer circumferential direction of the insulating spacer with the electromagnetic wave detector, the examined result that measurement at 8 positions can be performed if the entire circumference is observed and the above-described way of thinking in measurement for half circumference are adopted. First, the measurement is first performed at four positions spaced by 45°in the outer circumferential direction of the insulating spacer; and, only when an intensity distribution of electromagnetic waves peculiar to the TE11 mode appears in this range, then the measurement is performed at four positions spaced by 45°in the remaining circumferential direction for confirmation. It is sufficiently capable to determine the presence or absence of a partial discharge even such a measuring method is applied to the actual field measurement.

As described above, according to this embodiment of the present invention, the measurement position for measuring in the outer circumferential direction of the insulating spacer with the electromagnetic wave detector is set at 8 positions, evenly spaced in the outer circumferential direction of the insulating spacer; and therefore, the measurement can be efficiently performed.

Further, the measurement in the outer circumferential direction of the insulating spacer with the electromagnetic wave detector is first performed in a range of 1/2 of the entire circumference of the insulating spacer; and only when the intensity distribution of electromagnetic waves peculiar to the TE11 mode appears in this range, the remaining 1/2 is to be measured next; and therefore, the measurement operation can be saved and efficiently performed, and more particularly, many effects can be expected at the gas-insulated equipment in which many insulating spacers are provided, like a GIS.

Furthermore, the measurement in the outer circumferential direction of the insulating spacer with the electromagnetic wave detector is first performed in a range of 1/2 of the entire circumference of the insulating spacer; and only when the intensity distribution of electromagnetic waves peculiar to the TE11 mode appears in this range, the remaining 1/2 is to be measured next; and therefore, it can be further saved and efficiently performed compared to the above-mention.

Embodiment 5.

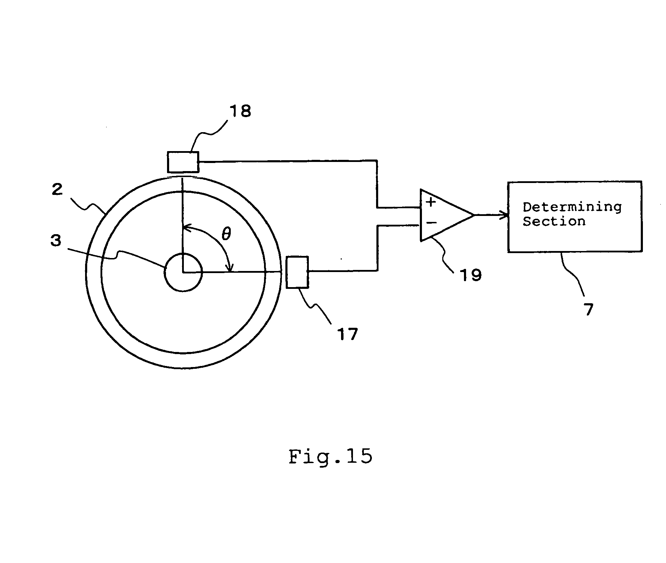

Next, a method of determining partial discharge according to Embodiment 5 will be described. Fig. 15 shows a sectional view in a direction perpendicular to a tank axis line at an insulating spacer part of a GIS. Since the configuration other than the parts shown in Fig. 15 are equivalent to Fig. 1 described in Embodiment 1, a detailed description thereof will not be repeated, and a description mainly about the points of difference will be given. In this embodiment, it is configured such that two electromagnetic wave detectors are used; a second electromagnetic wave detector 18 is disposed in the circumferential direction of the insulating spacer 2 with being spaced by 90° with respect to a first electromagnetic wave detector 17; a difference between two electromagnetic wave signals simultaneously detected by both electromagnetic wave detectors 17 and 18 is computed by a difference computing unit 19; and the value is inputted to the TE11 envelope detector 8 of the determining section 7.

It has been already described that, the method of determining partial discharge, using electromagnetic waves of the TE11 mode, utilizes that the intensity distribution of the TE11 mode has characteristic peak values which exist at positions, opposing by 180°, in the circumferential direction of the insulating spacer. Therefore, determination of a partial discharge can be accurately performed by measuring such a characteristic distribution; however, it is clear by the description so far that, for example, in the case where a peak is taken with the first electromagnetic wave detector 17, an intensity of the TE11 mode is almost never observed at a position of the second electromagnetic wave detector 18 spaced apart by 90°. The TE11 mode signal is not included in the signals obtained with the second electromagnetic wave detector 18, but only ambient noise is detected. Since the ambient noise is the entire noise of the measurement ambient, the ambient noise is naturally detected with the first electromagnetic wave detector 17 simultaneously. Therefore, only ambient noise is eliminated by computing a difference between both electromagnetic wave detectors 17 and 18 by the difference computing unit 19; if the signal is processed by the determining section, an intensity distribution of the TE11 mode of a partial discharge, which is not influenced by ambient noise, can be obtained.

In addition, it goes without saying that an interval with being spaced by 90° needs to be kept when both electromagnetic wave detectors 17 and 18 are moved.

As described above, according to this embodiment of the present invention, when electromagnetic waves are detected in the outer circumferential direction of an insulating spacer with an electromagnetic wave detector, a first electromagnetic wave detector is disposed in the circumferential direction with being spaced by 90° from a second electromagnetic wave detector, and it is determined on the basis of information by which a difference between two electromagnetic wave signals simultaneously detected by both electromagnetic wave detectors is computed by a computing unit; and therefore, influence by external noise can be eliminated and the presence or absence of a partial discharge can be accurately determined.

Embodiment 6.

Next, a system for determining partial discharge and a method of determining partial discharge according to Embodiment 6 will be described. The embodiments so far utilize the TE11 mode of the electromagnetic waves generated due to the partial discharge, but this embodiment utilizes the TE21 mode of a higher order.

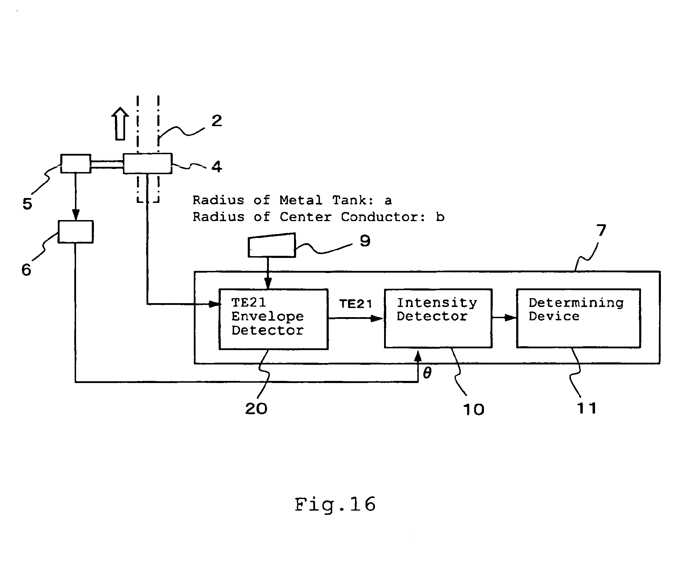

Since configurations of the system for determining partial discharge and the gas-insulated equipment are equivalent to Fig. 1 described in Embodiment 1, a detailed description thereof will not be repeated, and a description mainly about the points of difference will be given. The system for determining partial discharge is configured as shown in Fig. 16. One different from Fig. 1 is a point which substitutes a TE21 envelope detector 20 for the TE 11 envelope detector 8 in Fig. 1 and it will be appropriately described with reference to Fig. 1 to Fig. 4.

As in the description of Fig. 1 in Embodiment 1, the electromagnetic wave detector 4 is made to move by the moving device 5 along the outer circumferential direction of the insulating spacer 2 to detect electromagnetic wave signals which propagate in the metal tank, at a plurality of circumferential positions. At this time, information at the measurement position is detected by the displacement angle detector 6 as angle information θ, and it is transmitted to the intensity detector 10 of the determining section 7. In the determining section 7, the TE21 envelope detector 20, which receives output first from the electromagnetic wave detector 4, detects electromagnetic wave signals of the frequency band in which the TE21 mode propagates and the TE31 mode does not propagate from the received signals. At this time, diameter information of the metal tank and the center conductor are able to be inputted from the input section 9 as information necessary for computing a cutoff frequency. The detected TE21 mode signals are inputted to the intensity detector 10. The intensity detector 10 obtains an intensity distribution of electromagnetic waves in the outer circumferential direction of the metal tank based on the input signal and position information θ. It is configured so that the presence or absence of a partial discharge is determined by comparing the intensity distribution with a distribution peculiar to the TE21 mode with the determining device 11.

In addition, the frequency band in which the TE21 mode detected by the TE21 envelope detector 20 propagates but the TE31 mode does not propagate is a range not lower than the cutoff frequency of the TE21 mode, calculated according to Equation 1 based on the shape information (diameters of the metal tank and the center conductor) of the gas insulated equipment, and less than the cutoff frequency of the TE31 mode. In this regard, for actual usage, the frequency band need not to be strictly limited in the range and some tolerance may be provided at the front and back.

From the view point of versatility, that way is practical.

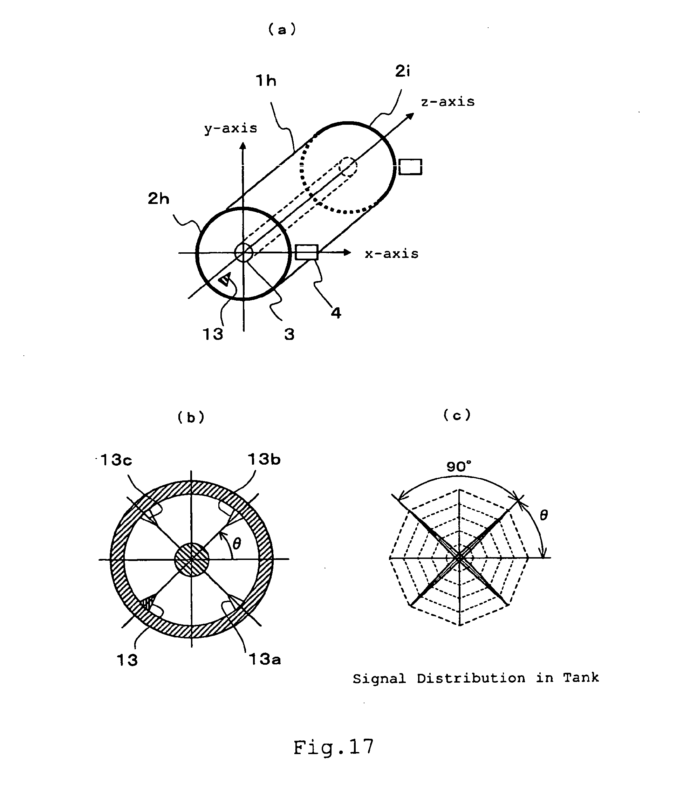

Next, a specific method of determining partial discharge using this system for determining partial discharge will be described. Fig. 17 is a view showing a gas insulation diagnostic method using the system for determining partial discharge of the present invention. Fig 17(a) is a typical view showing the case where a partial discharge occurs in the straight pipe metal tank 1h partitioned by two insulating spacers 2h and 2i. The partial discharge source 13 occurs, for example, at a position adjacent to the insulating spacer 2h and having an angle θ with respect to the horizontal direction (x-axis). Fig. 17(b) is a cross-sectional view in a direction perpendicular to the z-axis of an occurrence part of a partial discharge. Fig. 17(c) is an intensity distribution of the electromagnetic wave signal in which the electromagnetic wave signal due to a partial discharge observed at the insulating spacer parts 2h or 2i.

As shown in Fig. 17 (a), if a partial discharge occurs at a position of θ from the x-axis direction in the metal tank 1h, the intensity distribution of the electromagnetic wave of the TE21 observed at the insulating spacer part 2h has signal peaks which are observed at 4 points intervals of 90°with a central focus on the angle θ that the partial discharge source 13 is located as shown in (c). Therefore, if it can be confirmed that the intensity distribution of the electromagnetic wave signal obtained by measuring with the electromagnetic wave detector 4 at the insulating spacer part 2h is the intensity distribution which has 4 peak values at intervals of substantially 90°in the circumferential direction, it can be determined that it is the signal due to a partial discharge.

Further, the distribution shape having 4 peak values propagates without losing its shape if the straight pipe metal tank is used; the peak values exist at the same position even at the adjacent insulating spacer 2i, for example. Therefore, when the intensity distributions of the TE21 signals at two adjacent insulating spacers in the straight pipe metal tank 1h are compared and they exist at the same position, it is determined that the electromagnetic waves are due to the partial discharge in the metal tank. In addition, the distribution having the same peak appears at any position of 13a to 13c with respect to the partial discharge source 13.

As described above, a partial discharge can be determined by utilizing the TE21 mode instead of the TE11 mode. The TE21 mode has features that the frequency band is higher than the TE11 mode and is less subject to ambient noise. In this regard, however signal processing and determining algorithm become complicate. So, a method for effectively utilizing a system for determining partial discharge using the TE21 mode and a determining method will be described.

Even the system for determining partial discharge and the determining method, which utilize the TE11 mode previously described, can accurately determine a partial discharge. When a metal tank, in which occurrence of a partial discharge is doubtful by determining with the TE 11 mode, can be identified; as the next procedure, the metal tank is left open to eliminate a cause of occurrence of a partial discharge. This causes gas-insulated electrical substation equipment such as a GIS to cut off power supply for a long time and to require much cost and man power, thus it becomes important work to confirm that a partial discharge certainly occurs. Therefore, when occurrence of a partial discharge is found, there is a case where further confirmation work is required to make sure.

As for this confirmation work, if the determination utilizing the TE21 mode of this embodiment with respect to the metal tank concerned is added after determining with the TE11 mode, reliability of the determination is remarkably enhanced. As described above, since the TE21 mode has features that the frequency band is higher than the TE11 mode and is less subject to ambient noise; the verification with the TE21 mode is performed after the verification with the TE11 mode, and the presence of the peak values are confirmed at respective positions of substantially 90°, 180°, and 270°in the circumferential direction from peak values, whereby the confirmation work can be performed.

In addition, the case where the electromagnetic wave detector 4 is moved by the moving device 5 in Fig. 16 is described; however, the detector may be moved by an operator without depending on the moving device, or a plurality of the detectors may be disposed at preliminarily predetermined locations.

Further, when the presence or absence of a partial discharge is determined from a measurement result, if the pattern recognition device, for example, is used as the intensity detector 10, it is possible for a person of skill in the art to determine the presence or absence of a partial discharge by watching an intensity distribution without using the determining device 11 at especially subsequent stage. Therefore, the determining device 11 in the determining section 7 is not required as the system for determining partial discharge.

Furthermore, the case where the metal tank is of only the straight pipe is described; however, in the cases of L shape and T shape, it is possible to determine a partial discharge by comparing a measurement result with an intensity distribution, which is obtained by confirming a mode conversion at the branched part in the case of the TE21 as in the same way of thinking in the case of the TE 11 mode.

As described above, according to this embodiment of the present invention, the embodiment performs: detecting an electromagnetic wave signal at a plurality of outer circumferential positions of an insulating spacer; extracting a signal of a frequency band in which a TE21 mode propagates but a TE31 mode does not propagate with a TE21 envelope detector; detecting an intensity distribution of an outer circumferential electromagnetic waves in a metal tank from the intensity of the extracted signal and the circumferential position information of an electromagnetic wave detector; and determining the presence or absence of a partial discharge depending on whether or not the intensity distribution is indicative of a distribution peculiar to the TE21 mode, and therefore, a signal of the TE21 mode included in an electromagnetic wave caused by a partial discharge can be effectively captured and a feature peculiar to the mode can be extracted, thereby enabling the provision of a method of determining partial discharge or a system for determining partial discharge which can determine the presence or absence of a partial discharge with high reliability, without being affected by external noise.

Further, if this invention is performed as a confirmation work of a determination result of the method of determining partial discharge using the TE11 mode, the presence or absence of a partial discharge can be further accurately determined.

Further, determination of the presence or absence of partial discharge is performed by comparing the intensity distribution of the electromagnetic wave obtained by the intensity detector using the determining device with distribution peculiar to the TE21 mode, and therefore, further accurate determination can be performed in addition to the above-mentioned effects.

Furthermore, intensity distributions of electromagnetic waves, respectively measured at two insulating spacers mounted in the axial direction of a straight pipe metal tank, are compared to determine that a partial discharge occurs in the straight pipe if peak positions of both intensity distributions are the same; therefore, the presence or absence of a partial discharge in the straight pipe tank can be accurately determined.

Embodiment 7.

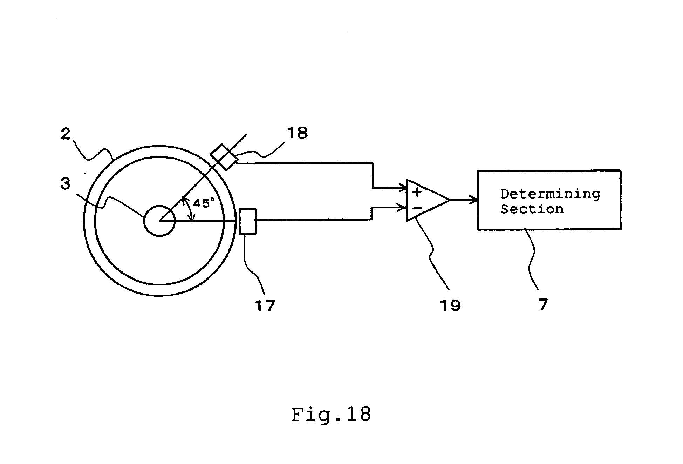

Next, Embodiment 7 will be described. Since the whole configuration of the system for determining partial discharge is equivalent to Embodiment 6, a detailed description thereof will not be repeated, and a description mainly about the points of difference will be given. The whole configuration drawing is fundamentally equivalent to Fig. 1 described in Embodiment 1. As shown in Fig. 18, main different point is to use two electromagnetic wave detectors, that is, the second electromagnetic wave detector 18 is disposed with being spaced by 90° from the first electromagnetic wave detector 17. It is configured that detection signals of both electromagnetic wave detectors 17 and 18 are inputted to the computing unit 19 differential signal is inputted to the determining section 7.

Next, operation will be described. The method of determining partial discharge, using electromagnetic waves of the TE21 mode, utilizes that the intensity distribution of the TE21 mode has characteristic peaks which exist at positions, opposing by 90°, in the circumferential direction of the insulating spacer. Therefore, determination of a partial discharge can be accurately performed by observing such a characteristic distribution, but there exist ambient noise during the measurement. Consequently, the ambient noise is measured with the second electromagnetic wave detector 18 to eliminate the noise by subtracting. The distribution of the electromagnetic wave has the peak values at 90°position as described above, but signals detected at a position spaced apart by 45°from the peak position with the second electromagnetic wave detector 18 include few TE21 mode and has only ambient noise; thus, signals that the ambient noise is eliminated can be taken by utilizing the difference between the signals simultaneously measured with both the electromagnetic wave detector 17 and 18.

In addition, it goes without saying that an interval with being spaced by 45° needs to be kept when both electromagnetic wave detectors 17 and 18 are moved.

As described above, according to this embodiment of the present invention, when electromagnetic waves are detected in the outer circumferential direction of an insulating spacer with an electromagnetic wave detector, a first electromagnetic wave detector is disposed in the circumferential direction with being spaced by 45° from a second electromagnetic wave detector, and a difference between two electromagnetic wave signals simultaneously detected by both electromagnetic wave detectors is computed by a computing unit and its value is inputted to the TE21 envelope detector; and therefore, influence by external noise can be eliminated and determination can be accurately performed.

While the presently preferred embodiments of the present invention have been shown and described. It is to be understood that these disclosures are for the purpose of illustration and that various changes and modifications may be made without departing from the scope of the invention as set forth in the appended claims.

INDUSTRIAL APPLICABILITY

The present invention is broadly suitable for detecting a partial discharge generated in electrical equipment having a coaxially disposed center conductor in a cylindrical metal tank, such as gas-insulated switchgear.

**Claims**

1. A method of determining a partial discharge, wherein gas-insulated equipment, which is configured so that a cylindrical metal tank (1, 1h) sealed with insulating gas is partitioned by insulating spacers (2, 2h, 2i) and a center conductor (3) is supported by the insulating spacers (2, 2h, 2i) the equipment is to be detected for determining the presence or absence of a partial discharge generated in the metal tank (1, 1h) by separating an electromagnetic wave signal propagating in the metal tank (1, 1h),
the method **characterized by** comprising the following steps:

- detecting the electromagnetic wave signal at a plurality of outer circumferential positions of the insulating spacer (2) with the electromagnetic wave detector (4), the electromagnetic wave signal propagating in the metal tank (1);
- extracting the signal of the frequency band in which the TE11 mode propagates, but the TE21 mode does not propagate by utilizing the cutoff frequency from the detected electromagnetic wave signal, with the TE 11 envelope detector (8);
- detecting the intensity distribution of outer circumferential electromagnetic waves in the metal tank (1) with the intensity detector (10, 14) from the intensity of the extracted signal and the circumferential position information of the electromagnetic wave detector (4); and
- determining the presence or absence of a partial discharge depending on whether or not the intensity distribution is indicative of a distribution of the TE11 mode having two peak values at positions substantially opposing each other by 180° in the circumferential direction.

2. The method according to claim 1,
**characterized by** determining the presence or absence of a partial discharge by comparing the intensity distribution of outer circumferential electromagnetic waves in the metal tank (1) detected with the intensity detector (10, 14) with the distribution of the TE11 mode by a determining device (11).

3. The method according to claim 1 or 2,
**characterized in that** the detection of the electromagnetic waves is performed by measurement while the electromagnetic wave detector (4) is moved along an outer circumferential direction of the insulating spacer (2) by a moving device (5).

4. The method according to any of claims 1 to 3,
**characterized in that** the detection of the electromagnetic waves is performed with the electromagnetic wave detectors (4) disposed at a plurality of outer circumferential positions of the insulating spacer (2).

5. The method according to any of claims 1 to 4,
**characterized by** further comprising the step of using a pattern recognition device (14) as the intensity detector (10).

6. The method according to any of claims 1 to 5,
**characterized by** further comprising the following steps:

- specifying an outer circumferential position where an output reaches a peak; and
- estimating a location of a partial discharge source in the circumferential direction of the metal tank (1) from the specified outer circumferential position.

7. The method according to any of claims 1 to 6,
**characterized by** further comprising the following steps:

- computing the cutoff frequency by inputting values of the diameter of the metal tank (1) and the diameter of the center conductor (3); and
- setting a frequency band to be detected by the TE11 envelope detector (8).

8. The method according to any of claims 1 to 7,
wherein the metal tank (1) is a straight pipe,
**characterized by** further comprising the following steps:

- comparing intensity distributions of electromagnetic waves respectively measured at two insulating spacer parts (2) mounted on both sides of the metal tank (1); and
- determining that a partial discharge occurs in the straight pipe if peak positions of both the intensity distributions are the same.

9. The method according to any of claims 1 to 7,

wherein the metal tank (1c, 1d) has an L-shaped bent part; and the metal tanks (1c, 1d) extending in two directions from the bent part are respectively provided with the insulating spacers (2c, 2d), **characterized by** further comprising the step of, when a plane including axis lines of the L-shaped metal tank (1c, 1d) is defined as a reference plane, determining that a partial discharge occurs in the L-shaped metal tank (1c, 1d) in the case where an intensity distribution having two peak values in a direction substantially parallel to the reference plane at one insulating spacer part (2c) is confirmed and an intensity distribution having signals in the entire circumference at the other insulating spacer part (2d) is confirmed.

10. The method according to any of claims 1 to 7, wherein the metal tank (1c, 1d) has an L-shaped bent part; and the metal tanks (1c, 1d) extending in two directions from the bent part are respectively provided with the insulating spacers (2c, 2d), **characterized by** further comprising the step of, when a plane including axis lines of the L-shaped metal tank (1c, 1d) is defined as a reference plane, determining that a partial discharge occurs in the L-shaped metal tank (1c, 1d) in the case where an intensity distribution having two peak values in a direction substantially perpendicular to the reference plane at the one insulating spacer part (2c) is confirmed and an intensity distribution also having two peak values in a direction substantially perpendicular to the reference plane at the other insulating spacer part (2d) is confirmed.

11. The method according to any of claims 1 to 7, wherein the metal tank (1c, 1d) has an L-shaped bent part; and the metal tanks (1c, 1d) extending in two directions from the bent part are respectively provided with the insulating spacers (2c, 2d), **characterized by** further comprising the step of, when a plane including axis lines of the L-shaped metal tank (1c, 1d) is defined as a reference plane, determining that a partial discharge occurs in the L-shaped metal tank (1c, 1d) in the case where an intensity distribution having two peak values in a direction substantially oblique with respect to the reference plane at one insulating spacer part (2c) is confirmed and an intensity distribution corresponding to a sum of a perpendicular direction component with respect to the reference plane and all circumferential direction components at the other insulating spacer part (2d) is confirmed.

12. The method according to any of claims 1 to 7, wherein the metal tank (1e, If, 1g) has a straight pipe part and a branch pipe part which is branched in a T-shape in the middle of the straight pipe part; and the metal tanks (1e, 1f, 1g) extending in three directions from the branched points are respectively provided with insulating spacers (2e, 2f, 2g), **characterized by** further comprising the step of, when a plane including axis lines of the T-shaped metal tank (1e, 1f, 1g) is defined as a reference plane, determining that a partial discharge occurs in the T-shaped metal tank (1e, 1f, 1g) in the case where an intensity distribution having two peak values in a direction substantially parallel to the reference plane at any one of the three insulating spacer parts (2e, 2f, 2g) is confirmed and an intensity distribution having signals in the entire circumference at the other two insulating spacer parts is confirmed.

13. The method according to any of claims 1 to 7, wherein the metal tank (1e, 1f, 1g) has a straight pipe part and a branch pipe part which is branched in a T-shape in the middle of the straight pipe part; and the metal tanks (1e, 1f, 1g) extending in three directions from the branched points are respectively provided with the insulating spacers (2e, 2f, 2g), **characterized by** further comprising the step of, when a plane including axis lines of the T-shaped metal tank (1e, 1f, 1g) is defined as a reference plane, determining that a partial discharge occurs in the T-shaped metal tank (1e, 1f, 1g) in the case where an intensity distribution having two peak values in a direction substantially perpendicular to the reference plane at all of the three insulating spacer parts is confirmed.

14. The method according to any of claims 1 to 7, wherein the metal tank (1e, 1f, 1g) has a straight pipe part and a branch pipe part which is branched in a T-shape in the middle of the straight pipe part; and the metal tanks (1e, 1f, 1g) extending in three directions from the branched points are respectively provided with the insulating spacers (2e, 2f, 2g), **characterized by** further comprising the step of, when a plane including axis lines of the T-shaped metal tank is defined as a reference plane, determining that a partial discharge occurs in the T-shaped metal tank (1e, 1f, 1g) in the case where an intensity distribution having two peak values in a direction substantially oblique with respect to the reference plane at any one of the three insulating spacer parts (2e, 2f, 2g) is confirmed and an intensity distribution corresponding to a sum of a perpendicular direction component with respect to the reference plane and all circumferential direction components at the other two insulating spacer parts is confirmed.

**15.** The method according to any of claims 1 to 14,
**characterized by** further comprising the step of setting measurement positions for measuring in the outer circumferential direction of the insulating spacer (2) with the electromagnetic wave detector (4), at eight equally spaced positions in the outer circumferential direction of the insulating spacer (2).

**16.** The method according to any of claims 1 to 15,
**characterized by** further comprising the following steps:

- performing measurement for measuring in the outer circumferential direction of the insulating spacer (2) with the electromagnetic wave detector (4), first in a range of 1/2 of the entire circumference of the insulating spacer (2); and then
- measuring the remaining 1/2 only when an intensity distribution of electromagnetic waves of a TE11 mode is observed in this range.

**17.** The method according to any of claims 1 to 16,
**characterized by** further comprising the following steps:

- performing measurement for measuring in the outer circumferential direction of the insulating spacer (2) with the electromagnetic wave detector (4), first at four positions spaced by 45° in the outer circumferential direction of the insulating spacer (2); and then
- measuring the remaining at four positions spaced by 45° only when an intensity distribution of electromagnetic waves of a TE11 mode is observed in this range.

**18.** The method according to any of claims 1 to 17,
wherein the electromagnetic wave detector (4), which detects electromagnetic waves in the outer circumferential direction of the insulating spacer (2), includes a first electromagnetic wave detector (17) and a second electromagnetic wave detector (18) spaced by 90° from the first electromagnetic wave detector (17),
**characterized by** further comprising the following steps:

- computing a difference between two electromagnetic wave signals simultaneously detected by the both electromagnetic wave detectors (17, 18) with a computing unit (19); and
- inputting the difference to the TE11 envelope detector (8).

**19.** A method of determining a partial discharge, wherein gas-insulated equipment, which is configured so that a cylindrical metal tank (1, 1h) sealed with insulating gas is partitioned by insulating spacers (2, 2h, 2i) and a center conductor (3) is supported by the insulating spacers (2, 2h, 2i) the equipment is to be detected for determining the presence or absence of a partial discharge generated in the metal tank (1, 1h) by separating an electromagnetic wave signal propagating in the metal tank (1, 1h),
the method **characterized by** comprising the following steps:

- detecting the electromagnetic wave signal at a plurality of outer circumferential positions of the insulating spacer (2h, 2i) with the electromagnetic wave detector (4), the electromagnetic wave signal propagating in the metal tank (1h); .
- extracting the signal of the frequency band in which the TE21 mode propagates, but the TE31 mode does not propagate by utilizing the cutoff frequency from the detected electromagnetic wave signal, with the TE21 envelope detector (20);
- detecting the intensity distribution of outer circumferential electromagnetic waves in the metal tank (1h) with the intensity detector (10) from the intensity of the extracted signal and the circumferential position information of the electromagnetic wave detector (4); and
- determining the presence or absence of a partial discharge depending on whether or not the intensity distribution is indicative of a distribution of the TE21 mode having four peaks at intervals of 90° in the circumferential direction.

**20.** The method according to claim 19,
**characterized by** determining the presence or absence of a partial discharge by comparing the intensity distribution of outer circumferential electromagnetic waves in the metal tank (1h) detected with the intensity detector (10) with the distribution of the TE21 mode by a determining device (11).

**21.** The method according to claim 19 or 20,

wherein the metal tank (1h) is a straight pipe,
**characterized by** further comprising the following steps:

- comparing intensity distributions of electromagnetic waves respectively measured at two insulating spacers (2h, 2i) mounted on both sides of the metal tank (1h); and
- determining that a partial discharge occurs in the straight pipe if peak positions of both the intensity distributions are the same.

22. The method according to any of claims 19 to 21, wherein the electromagnetic wave detector (4), which detects electromagnetic waves in the outer circumferential direction of the insulating spacer (2h, 2i), includes a first electromagnetic wave detector (17) and a second electromagnetic wave detector (18) spaced by 45°from the first electromagnetic wave detector (17),
**characterized by** further comprising the following steps:

- computing a difference between two electromagnetic wave signals simultaneously detected by the both electromagnetic wave detectors (17, 18) with a computing unit (19); and
- inputting the difference to the TE21 envelope detector (20).

23. A system for determining a partial discharge, wherein gas-insulated equipment, which is configured so that a cylindrical metal tank (1, 1h) sealed with insulating gas is partitioned by insulating spacers (2, 2h, 2i) and a center conductor (3) is supported by the insulating spacers (2, 2h, 2i) the equipment is to be detected for determining the presence or absence of a partial discharge generated in the metal tank (1, 1h) by separating an electromagnetic wave signal propagating in the metal tank (1, 1h),
the system **characterized by** comprising:

- an electromagnetic wave detector (4) for detecting the electromagnetic wave signal at a plurality of outer circumferential positions of the insulating spacer (2, 2h, 2i), the electromagnetic wave signal propagating in the metal tank (1, 1h);
- an envelope detector (8, 20) for extracting a signal of a frequency band in which a TE11 mode propagates, but a TE21 mode does not propagate or a signal of a frequency band in which a TE21 mode propagates, but a TE31 mode does not propagate by utilizing a cutoff frequency by receiving the detected electromagnetic wave signal; and
- an intensity detector (10, 14) for detecting an intensity distribution of outer circumferential electromagnetic waves in the metal tank (1, 1h) from the intensity of the extracted signal and the circumferential position information of the electromagnetic wave detector (4).

24. The system according to claim 23,
**characterized by** comprising:

- the electromagnetic wave detector (4) for detecting the electromagnetic wave signal at a plurality of outer circumferential positions of the insulating spacer (2), the electromagnetic wave signal propagating in the metal tank (1);
- the TE11 envelope detector (8) for extracting the signal of the frequency band in which the TE11 mode propagates, but the TE21 mode does not propagate by utilizing the cutoff frequency by receiving the detected electromagnetic wave signal; and
- the intensity detector (10, 14) for detecting the intensity distribution of outer circumferential electromagnetic waves in the metal tank (1) from the intensity of the extracted signal and the circumferential position information of the electromagnetic wave detector (4).

25. The system according to claim 24,
**characterized by** comprising a determining device (11) for determining the presence or absence of a partial discharge by comparing the intensity distribution of outer circumferential electromagnetic waves in the metal tank (1) detected with the intensity detector (10, 14) with a distribution of the TE11 mode.

26. The system according to claim 23,
**characterized by** comprising:

- the electromagnetic wave detector (4) for detecting the electromagnetic wave signal at a plurality of outer circumferential positions of the insulating spacer (2h, 2i), the electromagnetic wave signal propagating in the metal tank (1h);
- the TE21 envelope detector (20) for extracting the signal of the frequency band in which the TE21 mode propagates, but the TE31 mode does not propagate by utilizing the cutoff frequency by receiving the detected electromagnetic wave signal; and
- the intensity detector (10) for detecting the intensity distribution of outer circumferential electromagnetic waves in the metal tank (1h) from the intensity of the extracted signal and the circumferential position information of the electromagnetic wave detector (4).

**27.** The system according to claim 26,
**characterized by** comprising a determining device (11) for determining the presence or absence of a partial discharge by comparing the intensity distribution of outer circumferential electromagnetic waves in the metal tank (1h) detected with the intensity detector (10) with a distribution of the TE21 mode.

**Patentansprüche**

**1.** Verfahren zum Bestimmen einer Teilentladung, wobei eine gasisolierte Anlage, die derart ausgebildet ist, dass ein zylindrischer Metallbehälter (1, 1h) mit darin dicht eingeschlossenem Isoliergas durch isolierende Abstandshalter (2, 2h, 2i) unterteilt ist und ein Mittelleiter (3) durch die isolierenden Abstandshalter (2, 2h, 2i) gelagert ist, zu detektieren ist, um das Vorhandensein oder Nichtvorhandensein einer in dem Metallbehälter (1, 1h) erzeugten Teilentladung zu bestimmen, indem ein sich in dem Metallbehälter (1, 1h) ausbreitendes elektromagnetisches Wellensignal separiert wird, wobei das Verfahren **dadurch gekennzeichnet ist,**
**dass** es folgende Schritte aufweist:

- Detektieren des elektromagnetischen Wellensignals an einer Vielzahl von Außenumfangspositionen des isolierenden Abstandshalters (2) mittels eines Detektors (4) für elektromagnetische Wellen, wobei sich das elektromagnetische Wellensignal in dem Metallbehälter (1) ausbreitet;
- Extrahieren des Signals des Frequenzbands, in dem sich die TE11-Mode ausbreitet, sich jedoch die TE21-Mode nicht ausbreitet, unter Verwendung der Grenzfrequenz von dem detektierten elektromagnetischen Wellensignal mittels des TE11-Hüllkurvendetektors (8);
- Detektieren der Intensitätsverteilung von am Außenumfang befindlichen elektromagnetischen Wellen in dem Metallbehälter (1) mittels eines Intensitätsdetektors (10, 14) aus der Intensität des extrahierten Signals und der Umfangspositionsinformation des Detektors (4) für elektromagnetische Wellen; und
- Bestimmen des Vorhandenseins oder Nichtvorhandenseins einer Teilentladung in Abhängigkeit davon, ob die Intensitätsverteilung eine Verteilung der TE11-Mode mit zwei Spitzenwerten in Positionen, die einander in Umfangsrichtung im wesentlichen unter 180° gegenüberliegen, anzeigt oder nicht.

**2.** Verfahren nach Anspruch 1,
**dadurch gekennzeichnet,**
**dass** das Vorhandensein oder Nichtvorhandensein einer Teilentladung mittels einer Bestimmungsvorrichtung (11) bestimmt wird, indem die Intensitätsverteilung von am Außenumfang befindlichen elektromagnetischen Wellen in dem Metallbehälter (1), die mit dem Intensitätsdetektor (10, 14) detektiert wird, mit der Verteilung der TE 11-Mode verglichen wird.

**3.** Verfahren nach Anspruch 1 oder 2,
**dadurch gekennzeichnet,**
**dass** die Detektierung der elektromagnetischen Wellen durch Messungen ausgeführt wird, während der Detektor (4) für elektromagnetische Wellen mittels einer Bewegungsvorrichtung (5) entlang einer Außenumfangsrichtung des isolierenden Abstandshalters (2) bewegt wird.

**4.** Verfahren nach einem der Ansprüche 1 bis 3,
**dadurch gekennzeichnet,**
**dass** die Detektierung der elektromagnetischen Wellen mittels Detektoren (4) für elektromagnetische Wellen ausgeführt wird, die an einer Vielzahl von Außenumfangspositionen des isolierenden Abstandshalters (2) angeordnet werden.

**5.** Verfahren nach einem der Ansprüche 1 bis 4,

**dadurch gekennzeichnet,**
**dass** es ferner den Schritt aufweist, dass eine Mustererkennungsvorrichtung (14) als Intensitätsdetektor (10) verwendet wird.

6. Verfahren nach einem der Ansprüche 1 bis 5,
**dadurch gekennzeichnet,**
**dass** es ferner folgende Schritte aufweist:

- Spezifizieren einer Außenumfangsposition, an der ein Ausgang einen Spitzenwert erreicht; und
- Schätzen eines Ortes eines Teilentladungsursprungs in der Umfangsrichtung des Metallbehälters (1) aus der spezifizierten Außenumfangsposition.

7. Verfahren nach einem der Ansprüche 1 bis 6,
**dadurch gekennzeichnet,**
**dass** es ferner folgende Schritte aufweist:

- Berechnen der Grenzfrequenz durch Eingeben von Werten des Durchmessers des Metallbehälters (1) und des Durchmessers des Mittelleiters (3); und
- Vorgeben eines Frequenzbandes, das von dem TE11-Hüllkurvendetektor (8) detektiert werden soll.

8. Verfahren nach einem der Ansprüche 1 bis 7,
wobei der Metallbehälter (1) ein gerades Rohr ist,
**dadurch gekennzeichnet,**
**dass** es ferner folgende Schritte aufweist:

- Vergleichen von Intensitätsverteilungen von elektromagnetischen Wellen, die jeweils an zwei isolierenden Abstandshalterelementen (2) gemessen werden, die an beiden Seiten des Metallbehälters (1) angebracht sind; und
- Bestimmen, dass eine Teilentladung in dem geraden Rohr stattfindet, wenn Spitzenpositionen von beiden Intensitätsverteilungen gleich sind.

9. Verfahren nach einem der Ansprüche 1 bis 7,
wobei der Metallbehälter (1c, 1d) ein L-förmiges abgewinkeltes Teil aufweist; und wobei die sich in zwei Richtungen von dem abgewinkelten Teil weg erstreckenden Metallbehälter (1c, 1d) jeweils mit den isolierenden Abstandshaltern (2c, 2d) versehen sind,
**dadurch gekennzeichnet,**
**dass** es ferner folgenden Schritt aufweist:

wenn eine Ebene, die Achsenlinien des L-förmigen Metallbehälters (1c, 1d) beinhaltet, als Referenzebene definiert wird, Bestimmen, dass eine Teilentladung in dem L-förmigen Metallbehälter (1c, 1d) stattfindet, für den Fall, in dem eine Intensitätsverteilung mit zwei Spitzenwerten in einer Richtung im wesentlichen parallel zu der Referenzebene an dem einen isolierenden Abstandshalterelement (2c) bestätigt wird und eine Intensitätsverteilung mit Signalen in dem gesamten Umfang an dem anderen isolierenden Abstandshalterelement (2d) bestätigt wird.

10. Verfahren nach einem der Ansprüche 1 bis 7,
wobei der Metallbehälter (1c, 1d) ein L-förmiges abgewinkeltes Teil aufweist; und wobei die sich in zwei Richtungen von dem abgewinkelten Teil weg erstreckenden Metallbehälter (1c, 1d) jeweils mit den isolierenden Abstandshaltern (2c, 2d) versehen sind,
**dadurch gekennzeichnet,**
**dass** es ferner folgenden Schritt aufweist:

wenn eine Ebene, die Achsenlinien des L-förmigen Metallbehälters (1c, 1d) beinhaltet, als Referenzebene definiert wird, Bestimmen, dass eine Teilentladung in dem L-förmigen Metallbehälter (1c, 1d) stattfindet, für den Fall, in dem eine Intensitätsverteilung mit zwei Spitzenwerten in einer Richtung im wesentlichen senkrecht zu der Referenzebene an dem einen isolierenden Abstandshalterelement (2c) bestätigt wird und eine Intensitätsverteilung mit ebenfalls zwei Spitzenwerten in einer Richtung im wesentlichen senkrecht zu der Referenzebene an dem anderen isolierenden Abstandshalterelement (2d) bestätigt wird.

**11.** Verfahren nach einem der Ansprüche 1 bis 7,
wobei der Metallbehälter (1c, 1d) ein L-förmiges abgewinkeltes Teil aufweist; und wobei die sich in zwei Richtungen von dem abgewinkelten Teil weg erstreckenden Metallbehälter (1c, 1d) jeweils mit den isolierenden Abstandshaltern (2c, 2d) versehen sind,
**dadurch gekennzeichnet,**
**dass** es ferner folgenden Schritt aufweist:

wenn eine Ebene, die Achsenlinien des L-förmigen Metallbehälters (1c, 1d) beinhaltet, als Referenzebene definiert wird, Bestimmen, dass eine Teilentladung in dem L-förmigen Metallbehälter (1c, 1d) stattfindet, für den Fall, in dem eine Intensitätsverteilung mit zwei Spitzenwerten in einer Richtung im wesentlichen schräg zu der Referenzebene an dem einen isolierenden Abstandshalterelement (2c) bestätigt wird und eine Intensitätsverteilung entsprechend einer Summe einer rechtwinkligen Richtungskomponente in bezug auf die Referenzebene sowie allen Umfangsrichtungskomponenten an dem anderen isolierenden Abstandshalterelement (2d) bestätigt wird.

**12.** Verfahren nach einem der Ansprüche 1 bis 7,
wobei der Metallbehälter (1e, 1f, 1g) ein gerades Rohrteil und ein Zweigrohrteil aufweist, das in der Mitte des geraden Rohrteils T-förmig abzweigt; und wobei die sich in drei Richtungen von den Abzweigungspunkten weg erstreckenden Metallbehälter (1e, 1f, 1g) jeweils mit isolierenden Abstandshaltern (2e, 2f, 2g) versehen sind;
**dadurch gekennzeichnet,**
**dass** es ferner folgenden Schritt aufweist:

wenn eine Ebene, die Achsenlinien des T-förmigen Metallbehälters (1e, 1f, 1g) beinhaltet, als Referenzebene definiert wird, Bestimmen, dass eine Teilentladung in dem T-förmigen Metallbehälter (1e, 1f, 1g) stattfindet, für den Fall, in dem eine Intensitätsverteilung mit zwei Spitzenwerten in einer Richtung im wesentlichen parallel zu der Referenzebene an einem beliebigen von den drei isolierenden Abstandshalterelementen (2e, 2f, 2g) bestätigt wird und eine Intensitätsverteilung mit Signalen in dem gesamten Umfang an den beiden anderen isolierenden Abstandshalterelementen bestätigt wird.

**13.** Verfahren nach einem der Ansprüche 1 bis 7,
wobei der Metallbehälter (1e, 1f, 1g) ein gerades Rohrteil und ein Zweigrohrteil aufweist, das in der Mitte des geraden Rohrteils T-förmig abzweigt; und wobei die sich in drei Richtungen von den Abzweigungspunkten weg erstreckenden Metallbehälter (1e, 1f, 1g) jeweils mit isolierenden Abstandshaltern (2e, 2f, 2g) versehen sind;
**dadurch gekennzeichnet,**
**dass** es ferner folgenden Schritt aufweist:

wenn eine Ebene, die Achsenlinien des T-förmigen Metallbehälters (1e, 1f, 1g) beinhaltet, als Referenzebene definiert wird, Bestimmen, dass eine Teilentladung in dem T-förmigen Metallbehälter (1e, 1f, 1g) stattfindet, für den Fall, in dem eine Intensitätsverteilung mit zwei Spitzenwerten in einer Richtung im wesentlichen senkrecht zu der Referenzebene an allen von den drei isolierenden Abstandshalterelementen bestätigt wird.

**14.** Verfahren nach einem der Ansprüche 1 bis 7,
wobei der Metallbehälter (1e, 1f, 1g) ein gerades Rohrteil und ein Zweigrohrteil aufweist, das in der Mitte des geraden Rohrteils T-förmig abzweigt; und wobei die sich in drei Richtungen von den Abzweigungspunkten weg erstreckenden Metallbehälter (1e, 1f, 1g) jeweils mit isolierenden Abstandshaltern (2e, 2f, 2g) versehen sind;
**dadurch gekennzeichnet,**
**dass** es ferner folgenden Schritt aufweist:

wenn eine Ebene, die Achsenlinien des T-förmigen Metallbehälters (1e, 1f, 1g) beinhaltet, als Referenzebene definiert wird, Bestimmen, dass eine Teilentladung in dem T-förmigen Metallbehälter (1e, 1f, 1g) stattfindet, für den Fall, in dem eine Intensitätsverteilung mit zwei Spitzenwerten in einer Richtung im wesentlichen schräg zu der Referenzebene an einem beliebigen von den drei isolierenden Abstandshalterelementen (2e, 2f, 2g) bestätigt wird und eine Intensitätsverteilung entsprechend einer Summe einer rechtwinkligen Richtungskomponente in bezug auf die Referenzebene sowie allen Umfangsrichtungskomponenten an den anderen beiden isolierenden Abstandshalterelementen bestätigt wird.

**15.** Verfahren nach einem der Ansprüche 1 bis 14,
**dadurch gekennzeichnet,**

dass es ferner folgenden Schritt aufweist:

Vorgeben von Meßpositionen zum Messen in der Außenumfangsrichtung des isolierenden Abstandshalters (2) mittels des Detektors (4) für elektromagnetische Wellen an acht gleichmäßig voneinander beabstandeten Positionen in der Außenumfangsrichtung des isolierenden Abstandshalters (2).

16. Verfahren nach einem der Ansprüche 1 bis 15,
**dadurch gekennzeichnet,**
**dass** es ferner folgende Schritte aufweist:

- Ausführen eines Meßvorgangs zum Messen in der Außenumfangsrichtung des isolierenden Abstandshalters (2) mittels des Detektors (4) für elektromagnetische Wellen, zuerst in einem Bereich der Hälfte des gesamten Umfangs des isolierenden Abstandshalters (2); und dann
- Messen in der restlichen Hälfte nur dann, wenn eine Intensitätsverteilung von elektromagnetischen Wellen einer TE11-Mode in diesem Bereich beobachtet wird.

17. Verfahren nach einem der Ansprüche 1 bis 16,
**dadurch gekennzeichnet,**
**dass** es ferner folgende Schritte aufweist:

- Ausführen eines Meßvorgangs zum Messen in der Außenumfangsrichtung des isolierenden Abstandshalters (2) mittels des Detektors (4) für elektromagnetische Wellen, zuerst an vier Positionen, die um 45° in der Außenumfangsrichtung des isolierenden Abstandshalters (2) voneinander beabstandet sind; und dann
- Messen in dem verbleibenden Bereich an vier Positionen, die um 45° voneinander beabstandet sind, nur dann, wenn eine Intensitätsverteilung von elektromagnetischen Wellen einer TE11-Mode in diesem Bereich beobachtet wird.

18. Verfahren nach einem der Ansprüche 1 bis 17,
wobei der Detektor (4) für elektromagnetische Wellen (4), der elektromagnetische Wellen in der Außenumfangsrichtung des Abstandelements (2) detektiert, einen ersten Detektor (17) für elektromagnetische Wellen und einen zweiten Detektor (18) für elektromagnetische Wellen aufweist, der um 90° von dem ersten Detektor (17) für elektromagnetische Wellen beabstandet ist, **dadurch gekennzeichnet,**
**dass** es ferner folgende Schritte aufweist:

- Berechnen einer Differenz zwischen zwei elektromagnetischen Wellensignalen, die gleichzeitig von den beiden Detektoren (17, 18) für elektromagnetische Wellen detektiert werden, mittels einer Recheneinheit (19); und
- Eingeben der Differenz in den TE11-Hüllkurvendetektor (8).

19. Verfahren zum Bestimmen einer Teilentladung, wobei eine gasisolierte Anlage, die derart ausgebildet ist, dass ein zylindrischer Metallbehälter (1, 1h) mit darin dicht eingeschlossenem Isoliergas durch isolierende Abstandshalter (2, 2h, 2i) unterteilt ist und ein Mittelleiter (3) durch die isolierenden Abstandshalter (2, 2h, 2i) gelagert ist, zu detektieren ist, um das Vorhandensein oder Nichtvorhandensein einer in dem Metallbehälter (1, 1h) erzeugten Teilentladung zu bestimmen, indem ein sich in dem Metallbehälter (1, 1h) ausbreitendes elektromagnetisches Wellensignal separiert wird, wobei das Verfahren **dadurch gekennzeichnet ist,**
**dass** es folgende Schritte aufweist:

- Detektieren des elektromagnetischen Wellensignals an einer Vielzahl von Außenumfangspositionen des isolierenden Abstandshalters (2h, 2i) mittels des Detektors (4) für elektromagnetische Wellen, wobei sich das elektromagnetische Wellensignal in dem Metallbehälter (1h) ausbreitet;
- Extrahieren des Signals des Frequenzbands, in dem sich die TE21-Mode ausbreitet, sich jedoch die TE31-Mode nicht ausbreitet, unter Verwendung der Grenzfrequenz von dem detektierten elektromagnetischen Wellensignal mittels des TE21-Hüllkurvendetektors (20);
- Detektieren der Intensitätsverteilung von am Außenumfang befindlichen elektromagnetischen Wellen in dem Metallbehälter (1h) mittels des Intensitätsdetektors (10) aus der Intensität des extrahierten Signals und der Umfangspositionsinformation des Detektors (4) für elektromagnetische Wellen; und
- Bestimmen des Vorhandenseins oder Nichtvorhandenseins einer Teilentladung in Abhängigkeit davon, ob die Intensitätsverteilung eine Verteilung der TE21-Mode mit vier Spitzen in Intervallen von 90° in der Umfangsrichtung anzeigt oder nicht.

**20.** Verfahren nach Anspruch 19,
**dadurch gekennzeichnet,**
**dass** das Vorhandensein oder Nichtvorhandensein einer Teilentladung mittels einer Bestimmungsvorrichtung (11) bestimmt wird, indem die Intensitätsverteilung von am Außenumfang befindlichen elektromagnetischen Wellen in dem Metallbehälter (1h), die mit dem Intensitätsdetektor (10) detektiert wird, mit der Verteilung der TE21-Mode verglichen wird.

**21.** Verfahren nach Anspruch 19 oder 20,
wobei der Metallbehälter (1h) ein gerades Rohr ist,
**dadurch gekennzeichnet,**
**dass** es ferner folgende Schritte aufweist:

- Vergleichen von Intensitätsverteilungen von elektromagnetischen Wellen, die jeweils an zwei isolierenden Abstandshaltern (2h, 2i) gemessen werden, die an beiden Seiten des Metallbehälters (1) angebracht sind; und
- Bestimmen, dass eine Teilentladung in dem geraden Rohr stattfindet, wenn Spitzenpositionen von beiden Intensitätsverteilungen gleich sind.

**22.** Verfahren nach einem der Ansprüche 19 bis 21,
wobei der Detektor (4) für elektromagnetische Wellen (4), der elektromagnetische Wellen in der Außenumfangsrichtung des isolierenden Abstandelements (2h, 2i) detektiert, einen ersten Detektor (17) für elektromagnetische Wellen und einen zweiten Detektor (18) für elektromagnetische Wellen aufweist, der um 45° von dem ersten Detektor (17) für elektromagnetische Wellen beabstandet ist,
**dadurch gekennzeichnet,**
**dass** es ferner folgende Schritte aufweist:

- Berechnen einer Differenz zwischen zwei elektromagnetischen Wellensignalen, die gleichzeitig von den beiden Detektoren (17, 18) für elektromagnetische Wellen detektiert werden, mittels einer Recheneinheit (19); und
- Eingeben der Differenz in den TE21-Hüllkurvendetektor (20).

**23.** System zum Bestimmen einer Teilentladung, wobei eine gasisolierte Anlage, die derart ausgebildet ist, dass ein zylindrischer Metallbehälter (1, 1h) mit darin dicht eingeschlossenem Isoliergas durch isolierende Abstandshalter (2, 2h, 2i) unterteilt ist und ein Mittelleiter (3) durch die isolierenden Abstandshalter (2, 2h, 2i) gelagert ist, zu detektieren ist, um das Vorhandensein oder Nichtvorhandensein einer in dem Metallbehälter (1, 1h) erzeugten Teilentladung zu bestimmen, indem ein sich in dem Metallbehälter (1, 1h) ausbreitendes elektromagnetisches Wellensignal separiert wird, wobei das System **dadurch gekennzeichnet ist,**
**dass** es folgendes aufweist:

- einen Detektor (4) für elektromagnetische Wellen zum Detektieren des elektromagnetischen Wellensignals an einer Vielzahl von Außenumfangspositionen des isolierenden Abstandshalters (2, 2h, 2i), wobei sich das elektromagnetische Wellensignal in dem Metallbehälter (1, 1h) ausbreitet;
- einen Hüllkurvendetektor (8, 20) zum Extrahieren eines Signals eines Frequenzbands, in dem sich eine TE11-Mode ausbreitet, sich jedoch eine TE21-Mode nicht ausbreitet, oder eines Signals eines Frequenzbands, in dem sich eine TE21-Mode ausbreitet, sich jedoch eine TE31-Mode nicht ausbreitet, unter Verwendung einer Grenzfrequenz durch Empfangen des detektierten elektromagnetischen Wellensignals; und
- einen Intensitätsdetektor (10, 14) zum Detektieren einer Intensitätsverteilung von am Außenumfang befindlichen elektromagnetischen Wellen in dem Metallbehälter (1, 1h) aus der Intensität des extrahierten Signals und der Umfangspositionsinformation des Detektors (4) für elektromagnetische Wellen.

**24.** System nach Anspruch 23,
**dadurch gekennzeichnet,**
**dass** es folgendes aufweist:

- den Detektor (4) für elektromagnetische Wellen zum Detektieren des elektromagnetischen Wellensignals an einer Vielzahl von Außenumfangspositionen des isolierenden Abstandshalters (2), wobei sich das elektromagnetische Wellensignal in dem Metallbehälter (1) ausbreitet;
- den TE11-Hüllkurvendetektor (8) zum Extrahieren des Signals des Frequenzbands, in dem sich die TE11-Mode ausbreitet, sich jedoch die TE21-Mode nicht ausbreitet, unter Verwendung der Grenzfrequenz durch Empfangen des detektierten elektromagnetischen Wellensignals; und

- den Intensitätsdetektor (10, 14) zum Detektieren der Intensitätsverteilung von am Außenumfang befindlichen elektromagnetischen Wellen in dem Metallbehälter (1) aus der Intensität des extrahierten Signals und der Umfangspositionsinformation des Detektors (4) für elektromagnetische Wellen.

25. System nach Anspruch 24,
**dadurch gekennzeichnet,**
**dass** es eine Bestimmungsvorrichtung (11) aufweist zum Bestimmen des Vorhandenseins oder Nichtvorhandenseins einer Teilentladung durch Vergleichen der Intensitätsverteilung von am Außenumfang befindlichen elektromagnetischen Wellen in dem Metallbehälter (1), die mittels des Intensitätsdetektors (10, 14) detektiert wird, mit einer Verteilung der TE11-Mode.

26. System nach Anspruch 23,
**dadurch gekennzeichnet,**
**dass** es folgendes aufweist:

- den Detektor (4) für elektromagnetische Wellen zum Detektieren des elektromagnetischen Wellensignals an einer Vielzahl von Außenumfangspositionen des isolierenden Abstandshalters (2h, 2i), wobei sich das elektromagnetische Wellensignal in dem Metallbehälter (1h) ausbreitet;
- den TE21-Hüllkurvendetektor (20) zum Extrahieren des Signals des Frequenzbands, in dem sich die TE21-Mode ausbreitet, sich jedoch die TE31-Mode nicht ausbreitet, unter Verwendung der Grenzfrequenz durch Empfangen des detektierten elektromagnetischen Wellensignals; und
- den Intensitätsdetektor (10) zum Detektieren der Intensitätsverteilung von am Außenumfang befindlichen elektromagnetischen Wellen in dem Metallbehälter (1h) aus der Intensität des extrahierten Signals und der Umfangspositionsinformation des Detektors (4) für elektromagnetische Wellen.

27. System nach Anspruch 26,
**dadurch gekennzeichnet,**
**dass** es eine Bestimmungsvorrichtung (11) aufweist zum Bestimmen des Vorhandenseins oder Nichtvorhandenseins einer Teilentladung durch Vergleichen der Intensitätsverteilung von am Außenumfang befindlichen elektromagnetischen Wellen in dem Metallbehälter (1h), die mittels des Intensitätsdetektors (10) detektiert wird, mit einer Verteilung der TE21-Mode.

**Revendications**

1. Procédé de détermination d'une décharge partielle, dans lequel un équipement à isolation gazeuse, qui est configuré de manière qu'un réservoir métallique cylindrique (1, 1h) scellé avec un gaz isolant soit cloisonné par des entretoises isolantes (2, 2h, 2i) et qu'un conducteur central (3) soit supporté par les entretoises isolantes (2, 2h, 2i), l'équipement est destiné à être soumis à une détection pour déterminer la présence ou l'absence d'une décharge partielle générée dans le réservoir métallique (1, 1h) en séparant un signal d'ondes électromagnétiques se propageant dans le réservoir métallique (1, 1h),
le procédé étant **caractérisé en ce**
**qu'**il comprend les étapes suivantes:

- la détection du signal d'ondes électromagnétiques au niveau d'une pluralité de positions circonférentielles extérieures de l'entretoise isolante (2) avec le détecteur d'ondes électromagnétiques (4), le signal d'ondes électromagnétiques se propageant dans le réservoir métallique (1);
- l'extraction du signal de la bande de fréquences dans laquelle le mode TE11 se propage, mais le mode TE21 ne se propage pas, en utilisant la fréquence de coupure, à partir du signal d'ondes électromagnétiques détecté, avec le détecteur d'enveloppe TE11 (8);
- la détection de la distribution d'intensité des ondes électromagnétiques circonférentielles extérieures dans le réservoir métallique (1) avec le détecteur d'intensité (10, 14) à partir de l'intensité du signal extrait et des informations de position circonférentielle du détecteur d'ondes électromagnétiques (4); et
- la détermination de la présence ou l'absence d'une décharge partielle en fonction du fait que la distribution d'intensité est ou non indicative d'une distribution du mode TE11 ayant deux valeurs de crête dans des positions sensiblement opposées entre elles de 180° dans la direction circonférentielle.

2. Procédé selon la revendication 1,

**caractérisé par** la détermination de la présence ou l'absence d'une décharge partielle en comparant la distribution d'intensité des ondes électromagnétiques circonférentielles extérieures dans le réservoir métallique (1) détectée avec le détecteur d'intensité (10, 14) avec la distribution du mode TE11 par un dispositif de détermination (11).

3. Procédé selon la revendication 1 ou 2,
**caractérisé en ce que** la détection des ondes électromagnétiques est effectuée par mesure alors que le détecteur d'ondes électromagnétiques (4) est déplacé suivant une direction circonférentielle extérieure de l'entretoise isolante (2) par un dispositif de déplacement (5).

4. Procédé selon l'une quelconque des revendications 1 à 3,
**caractérisé en ce que** la détection des ondes électromagnétiques est effectuée avec les détecteurs d'ondes électromagnétiques (4) disposés au niveau d'une pluralité de positions circonférentielles extérieures de l'entretoise isolante (2).

5. Procédé selon l'une quelconque des revendications 1 à 4,
**caractérisé en ce qu'**il comprend en outre l'étape d'utilisation d'un dispositif de reconnaissance de formes (14) comme le détecteur d'intensité (10).

6. Procédé selon l'une quelconque des revendications 1 à 5,
**caractérisé en ce qu'**il comprend en outre les étapes suivantes:

   - la spécification d'une position circonférentielle extérieure où une sortie atteint un pic; et
   - l'estimation d'une position d'une source de décharge partielle dans la direction circonférentielle du réservoir métallique (1) à partir de la position circonférentielle extérieure spécifiée.

7. Procédé selon l'une quelconque des revendications 1 à 6,
**caractérisé en ce qu'**il comprend en outre les étapes suivantes:

   - le calcul de la fréquence de coupure en entrant des valeurs du diamètre du réservoir métallique (1) et du diamètre du conducteur central (3); et
   - la détermination d'une bande de fréquences à détecter par le détecteur d'enveloppe TE11 (8).

8. Procédé selon l'une quelconque des revendications 1 à 7,
dans lequel le réservoir métallique (1) est un tube droit,
**caractérisé en ce qu'**il comprend en outre les étapes suivantes:

   - la comparaison de distributions d'intensité d'ondes électromagnétiques mesurées respectivement au niveau de deux parties d'entretoise isolante (2) montées sur les deux côtés du réservoir métallique (1); et
   - la détermination du fait qu'une décharge partielle se produit dans le tube droit si des positions de crête des deux distributions d'intensité sont les mêmes.

9. Procédé selon l'une quelconque des revendications 1 à 7,
dans lequel le réservoir métallique (1c, 1d) a une partie pliée en forme de L; et les réservoirs métalliques (1c, 1d) s'étendant dans deux directions à partir de la partie pliée sont respectivement pourvus des entretoises isolantes (2c, 2d),
**caractérisé en ce qu'**il comprend en outre l'étape, quand un plan comprenant des lignes d'axe du réservoir métallique en forme de L (1c, 1d) est défini comme un plan de référence, de détermination du fait qu'une décharge partielle se produit dans le réservoir métallique en forme de L (1c, 1d) dans le cas où une distribution d'intensité ayant deux valeurs de crête dans une direction sensiblement parallèle au plan de référence au niveau d'une partie d'entretoise isolante (2c) est confirmée et une distribution d'intensité ayant des signaux dans toute la circonférence au niveau de l'autre partie d'entretoise isolante (2d) est confirmée.

10. Procédé selon l'une quelconque des revendications 1 à 7,
dans lequel le réservoir métallique (1c, 1d) a une partie pliée en forme de L; et les réservoirs métalliques (1c, 1d) s'étendant dans deux directions à partir de la partie pliée sont respectivement pourvus des entretoises isolantes (2c, 2d),
**caractérisé en ce qu'**il comprend en outre l'étape, quand un plan comprenant des lignes d'axe du réservoir métallique en forme de L (1c, 1d) est défini comme un plan de référence, de détermination du fait qu'une décharge partielle se produit dans le réservoir métallique en forme de L (1c, 1d) dans le cas où une distribution d'intensité ayant deux valeurs de crête dans une direction sensiblement perpendiculaire au plan de référence au niveau d'une partie d'entretoise isolante (2c) est confirmée et une distribution d'intensité ayant également deux valeurs de crête dans une direction sensiblement perpendiculaire au plan de référence au niveau de l'autre partie d'entretoise isolante (2d) est confirmée.

11. Procédé selon l'une quelconque des revendications 1 à 7,
dans lequel le réservoir métallique (1c, 1d) a une partie pliée en forme de L; et les réservoirs métalliques (1c, 1d) s'étendant dans deux directions à partir de la partie pliée sont respectivement pourvus des entretoises isolantes (2c, 2d),
**caractérisé en ce qu'**il comprend en outre l'étape, quand un plan comprenant des lignes d'axe du réservoir métallique en forme de L (1c, 1d) est défini comme un plan de référence, de détermination du fait qu'une décharge partielle se produit dans le réservoir métallique en forme de L (1c, 1d) dans le cas où une distribution d'intensité ayant deux valeurs de crête dans une direction sensiblement oblique par rapport au plan de référence au niveau d'une partie d'entretoise isolante (2c) est confirmée et une distribution d'intensité correspondant à une somme d'une composante de direction perpendiculaire par rapport au plan de référence et toutes les composantes de direction circonférentielle au niveau de l'autre partie d'entretoise isolante (2d) est confirmée.

12. Procédé selon l'une quelconque des revendications 1 à 7,
dans lequel le réservoir métallique (1e, 1f, 1 g) a une partie de tube droit et une partie de tube de raccordement qui est raccordée en forme de T au milieu de la partie de tube droit; et les réservoirs métalliques (1e, 1f, 1g) s'étendant dans trois directions à partir des points raccordés sont respectivement munis d'entretoises isolantes (2e, 2f, 2g),
**caractérisé en ce qu'**il comprend en outre l'étape, quand un plan comprenant des lignes d'axe du réservoir métallique en forme de T (1e, 1f, 1 g) est défini comme un plan de référence, de détermination du fait qu'une décharge partielle se produit dans le réservoir métallique en forme de T (1e, 1f, 1g) dans le cas où une distribution d'intensité ayant deux valeurs de crête dans une direction sensiblement parallèle au plan de référence au niveau de l'une quelconque des trois parties d'entretoise isolante (2e, 2f, 2g) est confirmée et une distribution d'intensité ayant des signaux dans toute la circonférence au niveau des deux autres parties d'entretoise isolante est confirmée.

13. Procédé selon l'une quelconque des revendications 1 à 7,
dans lequel le réservoir métallique (1e, 1f, 1 g) a une partie de tube droit et une partie de tube de raccordement qui est raccordée en forme de T au milieu de la partie de tube droit; et les réservoirs métalliques (1e, 1f, 1g) s'étendant dans trois directions à partir des points raccordés sont respectivement munis d'entretoises isolantes (2e, 2f, 2g),
**caractérisé en ce qu'**il comprend en outre l'étape, quand un plan comprenant des lignes d'axe du réservoir métallique en forme de T (1e, 1f, 1g) est défini comme un plan de référence, de détermination du fait qu'une décharge partielle se produit dans le réservoir métallique en forme de T (1e, 1f, 1g) dans le cas où une distribution d'intensité ayant deux valeurs de crête dans une direction sensiblement perpendiculaire au plan de référence au niveau de la totalité des trois parties d'entretoise isolante est confirmée.

14. Procédé selon l'une quelconque des revendications 1 à 7,
dans lequel le réservoir métallique (1e, 1f, 1 g) a une partie de tube droit et une partie de tube de raccordement qui est raccordée en forme de T au milieu de la partie de tube droit; et les réservoirs métalliques (1e, 1f, 1 g) s'étendant dans trois directions à partir des points raccordés sont respectivement munis d'entretoises isolantes (2e, 2f, 2g),
**caractérisé en ce qu'**il comprend en outre l'étape, quand un plan comprenant des lignes d'axe du réservoir métallique en forme de T est défini comme un plan de référence, de détermination du fait qu'une décharge partielle se produit dans le réservoir métallique en forme de T (1e, 1f, 1g) dans le cas où une distribution d'intensité ayant deux valeurs de crête dans une direction sensiblement oblique par rapport au plan de référence au niveau de l'une quelconque des trois parties d'entretoise isolante (2e, 2f, 2g) est confirmée et une distribution d'intensité correspondant à une somme d'une composante de direction perpendiculaire par rapport au plan de référence et toutes les composantes de direction circonférentielle au niveau des deux autres parties d'entretoise isolante est confirmée.

15. Procédé selon l'une quelconque des revendications 1 à 14, **caractérisé en ce qu'**il comprend en outre l'étape de détermination de positions de mesure pour la mesure dans la direction circonférentielle extérieure de l'entretoise isolante (2) avec le détecteur d'ondes électromagnétiques (4), dans huit positions équidistantes dans la direction circonférentielle extérieure de l'entretoise isolante (2).

16. Procédé selon l'une quelconque des revendications 1 à 15, **caractérisé en ce qu'**il comprend en outre les étapes suivantes:

- l'exécution d'une mesure pour la mesure dans la direction circonférentielle extérieure de l'entretoise isolante (2) avec le détecteur d'ondes électromagnétiques (4), d'abord dans une plage de 1/2 de la circonférence totale de l'entretoise isolante (2); et ensuite

- la mesure du 1/2 restant seulement quand une distribution d'intensité d'ondes électromagnétiques d'un mode TE11 est observée dans cette plage.

17. Procédé selon l'une quelconque des revendications 1 à 16, **caractérisé en ce qu'**il comprend en outre les étapes suivantes:

- l'exécution d'une mesure pour la mesure dans la direction circonférentielle extérieure de l'entretoise isolante (2) avec le détecteur d'ondes électromagnétiques (4), d'abord dans quatre positions espacées de 45° dans la direction circonférentielle extérieure de l'entretoise isolante (2); et ensuite

- la mesure du reste dans quatre positions espacées de 45° seulement quand une distribution d'intensité d'ondes électromagnétiques d'un mode TE11 est observée dans cette plage.

18. Procédé selon l'une quelconque des revendications 1 à 17,
dans lequel le détecteur d'ondes électromagnétiques (4), qui détecte des ondes électromagnétiques dans la direction circonférentielle extérieure de l'entretoise isolante (2) comprend un premier détecteur d'ondes électromagnétiques (17) et un deuxième détecteur d'ondes électromagnétiques (18) espacé de 90° par rapport au premier détecteur d'ondes électromagnétiques (17),
**caractérisé en ce qu'**il comprend en outre les étapes suivantes:

- le calcul d'une différence entre deux signaux d'ondes électromagnétiques détectés simultanément par les deux détecteurs d'ondes électromagnétiques (17, 18) avec une unité de calcul (19); et
- l'application de la différence en entrée du détecteur d'enveloppe TE11 (8).

19. Procédé de détermination d'une décharge partielle, dans lequel un équipement à isolation gazeuse, qui est configuré de manière qu'un réservoir métallique cylindrique (1, 1h) scellé avec un gaz isolant soit cloisonné par des entretoises isolantes (2, 2h, 2i) et qu'un conducteur central (3) soit supporté par les entretoises isolantes (2, 2h, 2i), l'équipement est destiné à être soumis à une détection pour déterminer la présence ou l'absence d'une décharge partielle générée dans le réservoir métallique (1, 1h) en séparant un signal d'ondes électromagnétiques se propageant dans le réservoir métallique (1, 1h),
le procédé étant **caractérisé en ce qu'**il comprend les étapes suivantes:

- la détection du signal d'ondes électromagnétiques au niveau d'une pluralité de positions circonférentielles extérieures de l'entretoise isolante (2h, 2i) avec le détecteur d'ondes électromagnétiques (4), le signal d'ondes électromagnétiques se propageant dans le réservoir métallique (1h);
- l'extraction du signal de la bande de fréquences dans laquelle le mode TE21 se propage, mais le mode TE31 ne se propage pas, en utilisant la fréquence de coupure, à partir du signal d'ondes électromagnétiques détecté, avec le détecteur d'enveloppe TE21 (20);
- la détection de la distribution d'intensité des ondes électromagnétiques circonférentielles extérieures dans le réservoir métallique (1h) avec le détecteur d'intensité (10) à partir de l'intensité du signal extrait et des informations de position circonférentielle du détecteur d'ondes électromagnétiques (4); et
- la détermination de la présence ou l'absence d'une décharge partielle en fonction du fait que la distribution d'intensité est ou non indicative d'une distribution du mode TE21 ayant quatre valeurs de crête à des intervalles de 90° dans la direction circonférentielle.

20. Procédé selon la revendication 19,
**caractérisé par** la détermination de la présence ou l'absence d'une décharge partielle en comparant la distribution d'intensité des ondes électromagnétiques circonférentielles extérieures dans le réservoir métallique (1h) détectée avec le détecteur d'intensité (10) avec la distribution du mode TE21 par un dispositif de détermination (11).

21. Procédé selon la revendication 19 ou 20,
dans lequel le réservoir métallique (1h) est un tube droit,
**caractérisé en ce qu'**il comprend en outre les étapes suivantes:

- la comparaison de distributions d'intensité d'ondes électromagnétiques mesurées respectivement au niveau de deux entretoises isolantes (2h, 2i) montées sur les deux côtés du réservoir métallique (1h); et

- la détermination du fait qu'une décharge partielle se produit dans le tube droit si des positions de crête des deux distributions d'intensité sont les mêmes.

**22.** Procédé selon l'une quelconque des revendications 19 à 21,
dans lequel le détecteur d'ondes électromagnétiques (4), qui détecte des ondes électromagnétiques dans la direction circonférentielle extérieure de l'entretoise isolante (2h, 2i) comprend un premier détecteur d'ondes électromagnétiques (17) et un deuxième détecteur d'ondes électromagnétiques (18) espacé de 45° par rapport au premier détecteur d'ondes électromagnétiques (17),
**caractérisé en ce qu'**il comprend en outre les étapes suivantes:

- le calcul d'une différence entre deux signaux d'ondes électromagnétiques détectés simultanément par les deux détecteurs d'ondes électromagnétiques (17, 18) avec une unité de calcul (19); et
- l'application de la différence en entrée du détecteur d'enveloppe TE21 (20).

**23.** Système pour la détermination d'une décharge partielle, dans lequel un équipement à isolation gazeuse, qui est configuré de manière qu'un réservoir métallique cylindrique (1, 1h) scellé avec un gaz isolant soit cloisonné par des entretoises isolantes (2, 2h, 2i) et qu'un conducteur central (3) soit supporté par les entretoises isolantes (2, 2h, 2i), l'équipement est destiné à être soumis à une détection pour déterminer la présence ou l'absence d'une décharge partielle générée dans le réservoir métallique (1, 1h) en séparant un signal d'ondes électromagnétiques se propageant dans le réservoir métallique (1, 1h),
le système étant **caractérisé en ce qu'**il comprend:

- un détecteur d'ondes électromagnétiques (4) pour détecter le signal d'ondes électromagnétiques au niveau d'une pluralité de positions circonférentielles extérieures de l'entretoise isolante (2, 2h, 2i), le signal d'ondes électromagnétiques se propageant dans le réservoir métallique (1, 1h);
- un détecteur d'enveloppe (8, 20) pour extraire un signal d'une bande de fréquences dans laquelle un mode TE11 se propage, mais un mode TE21 ne se propage pas ou un signal d'une bande de fréquences dans laquelle un mode TE21 se propage, mais un mode TE31 ne se propage pas, en utilisant une fréquence de coupure, en recevant le signal d'ondes électromagnétiques détecté; et
- un détecteur d'intensité (10, 14) pour détecter une distribution d'intensité des ondes électromagnétiques circonférentielles extérieures dans le réservoir métallique (1, 1h) à partir de l'intensité du signal extrait et des informations de position circonférentielle du détecteur d'ondes électromagnétiques (4).

**24.** Système selon la revendication 23,
**caractérisé en ce qu'**il comprend:

- le détecteur d'ondes électromagnétiques (4) pour détecter le signal d'ondes électromagnétiques au niveau d'une pluralité de positions circonférentielles extérieures de l'entretoise isolante (2), le signal d'ondes électromagnétiques se propageant dans le réservoir métallique (1);
- le détecteur d'enveloppe TE11 (8) pour extraire le signal de la bande de fréquences dans laquelle le mode TE11 se propage, mais le mode TE21 ne se propage pas, en utilisant la fréquence de coupure, en recevant le signal d'ondes électromagnétiques détecté; et
- le détecteur d'intensité (10, 14) pour détecter la distribution d'intensité des ondes électromagnétiques circonférentielles extérieures dans le réservoir métallique (1) à partir de l'intensité du signal extrait et des informations de position circonférentielle du détecteur d'ondes électromagnétiques (4).

**25.** Système selon la revendication 24,
**caractérisé en ce qu'**il comprend un dispositif de détermination (11) pour déterminer la présence ou l'absence d'une décharge partielle en comparant la distribution d'intensité d'ondes électromagnétiques circonférentielles extérieures dans le réservoir métallique (1) détectée avec le détecteur d'intensité (10, 14) avec une distribution du mode TE11.

**26.** Système selon la revendication 23,
**caractérisé en ce qu'**il comprend:

- le détecteur d'ondes électromagnétiques (4) pour détecter le signal d'ondes électromagnétiques au niveau d'une pluralité de positions circonférentielles extérieures de l'entretoise isolante (2h, 2i), le signal d'ondes électromagnétiques se propageant dans le réservoir métallique (1h);

- le détecteur d'enveloppe TE21 (20) pour extraire le signal de la bande de fréquences dans laquelle le mode TE21 se propage, mais le mode TE31 ne se propage pas, en utilisant la fréquence de coupure, en recevant le signal d'ondes électromagnétiques détecté; et
- le détecteur d'intensité (10) pour détecter la distribution d'intensité des ondes électromagnétiques circonférentielles extérieures dans le réservoir métallique (1h) à partir de l'intensité du signal extrait et des informations de position circonférentielle du détecteur d'ondes électromagnétiques (4).

27. Système selon la revendication 26,
**caractérisé en ce qu'**il comprend un dispositif de détermination (11) pour déterminer la présence ou l'absence d'une décharge partielle en comparant la distribution d'intensité d'ondes électromagnétiques circonférentielles extérieures dans le réservoir métallique (1h) détectée avec le détecteur d'intensité (10) avec une distribution du mode TE21.

Radius of Metal Tank: a
Radius of Center Conductor: b

Fig.1

Fig.2

TEM Mode          TE11 Mode          TE21 Mode

Fig.3

Fig.4

(a)

(b)

(c)

Signal Distribution
in Tank

Fig.5

Radius of Metal Tank: a
Radius of Center Conductor: b

Fig.6

Fig.7

(a)

(b)

Insulating
Spacer 2c

(c)

Insulating
spacer 2d

TE11 Mode Intensity Distribution

Fig.8

(a)

(b)

Insulating
Spacer 2c

(c)

Insulating
Spacer 2d

TE11 Mode Intensity Distribution

Fig.9

( a )

( b )

Fig.10

(a)

z-axis

1g

2g

1e

y-axis

2e

2f

3

x-axis

13

1f

4

4

16

(b)

(c)

(d)

Insulating
Spacer 2e

Insulating
Spacer 2f

Insulating
Spacer 2g

TE11 Mode Intensity Distribution

Fig.11

( a )

( b )                    ( c )

Insulating              Insulating
Spacer 2f               spacer 2e,2g

TE11 Mode Intensity Distribution

Fig.12

(a)

(b)                    (c)                    (d)

Insulating             Insulating             Insulating
Spacer 2e              Spacer 2f              Spacer 2g

TE11 Mode Intensity Distribution

Fig.13

EP 1 705 491 B1

( a )

( b ) ( c )

Insulating
Spacer 2f

Insulating
Spacer 2e,2g

TE11 Mode Intensity Distribution

Fig.14

42

Fig.15

Radius of Metal Tank: a
Radius of Center Conductor: b

| TE21 Envelope Detector | TE21 | Intensity Detector | | Determining Device |

Fig.16

( a )

( b )

( c )

Signal Distribution in Tank

Fig.17

Fig.18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000102159 A